# EUROPEAN PATENT SPECIFICATION

(11) **EP 2 805 358 B1**
(45) Date of publication and mention of the grant of the patent: **30.11.2016**
(21) Application number: 13738253.7
(22) Date of filing: 18.01.2013
(51) Int. Cl.: H01L 31/18, H01L 31/042, C23C 14/00, C23C 14/06, C23C 14/24, C23C 14/34, C23C 14/35, C23C 14/56

(54) **SYSTEMS FOR FORMING PHOTOVOLTAIC CELLS ON FLEXIBLE SUBSTRATES**
SYSTEME ZUR HERSTELLUNG VON PHOTOVOLTAISCHEN ZELLEN AUF FLEXIBLEN SUBSTRATEN
SYSTÈMES DE FORMATION DE CELLULES PHOTOVOLTAÏQUES SUR SUBSTRATS FLEXIBLES

(30) Priority: 18.01.2012 US 201261587994 P
(43) Date of publication of application: 26.11.2014
(73) Proprietor: Nuvosun, Inc., Milpitas, CA 95035 (US)
(72) Inventor: HACHTMANN, Bruce, D., San Martin, CA 95046 (US); BONIGUT, Josef, Alamo, CA 94507 (US); QIAN, Qing, San Jose, CA 95129 (US); HOLLARS, Dennis, R., San Jose, CA 95124 (US); LIU, Xiaodong, Pudong, Shanghai, 602 (CN)
(74) Representative: Beck Greener
(86) International application number: PCT/US2013/022284
(87) International publication number: WO 2013/109977

(56) References cited:
- EP-A1- 2 216 831
- US-A1- 2004 131 761
- US-A1- 2008 182 358
- US-A1- 2009 215 224
- US-A1- 2009 255 461

## Description

### CROSS-REFERENCE

This application claims priority to U.S. Provisional Patent Application Serial No. 61/587,994, filed January 18, 2012, which application is entirely incorporated herein by reference.

### BACKGROUND

A thin film solar (or photovoltaic) cell may be formed by depositing material layers on a substrate. Such material layers may include photoactive layers. Material layers may be deposited sequentially with the aid of deposition systems. A photovoltaic device structure may be formed following the deposition of various material layers, including an absorber of the photovoltaic device.

There are various depositions systems and methods for forming thin film photovoltaic cells. Such systems include vapor phase deposition systems and sputtering systems. Examples of deposition systems include roll-to-roll deposition systems.

### SUMMARY

While there are systems presently available for forming thin film solar (or photovoltaic) cells, recognized herein are various limitations associated with such systems. For instance, systems that use evaporation for the deposition of thin films and chemical vapor deposition systems may experience much more difficulty in maintaining compositional control than those that employ sputtering, and the deposition rates of such evaporation systems are typically lower that sputtering systems.

While there are sputtering systems (e.g., roll-to-roll sputtering systems) presently available for forming photovoltaic cells, such systems may not be capable of monitoring individual layers of a photovoltaic cell, since, for example, a given layer is interactive and formed simultaneously with other layers. Further, each station of a roll-to-roll sputtering system should work with high yield at all times or else some well formed layers will be compromised with poorly formed layers, lowering the net yield of the process as a whole. A failure in one part of the system necessitates stopping the entire roll-to-roll process, which can disadvantageously lead to downtime. Some roll-to-roll processes use substrate web payout and take up (or pickup) drums to support the substrate. A disadvantage of such processes can lead to limited substrate temperatures and increased difficulty in web handling for thin metallic substrates that have a much higher modulus than polymeric substrates.

In view of at least some of the herein-recognized limitations of systems and methods presently available for forming photovoltaic cells, what is needed are improved systems and methods for forming photovoltaic cells.

This disclosure provides roll coating systems having flexibility for depositing various layers of a thin film solar cell. A system for forming photovoltaic cells can include a plurality of modules, with each module configured to deposit one of the layers of the cell. As such, a problem with one layer can be corrected while production proceeds on the other machines. The present disclosure describes the architecture for a roll-to-roll coating machine which can overcome at least some of the disadvantages of current systems.

This disclosure provides sputter deposition systems and methods for coating materials on thin flexible substrates in roll form. Some embodiments provide sputtering apparatuses (e.g., mini chambers) and methods for forming various layers of thin film solar cells on rolls of thin flexible metallic substrates. Systems of the disclosure provide for the formation of photovoltaic cells in a relatively rapid and economical fashion.

This disclosure provides a machine that can be used to produce thin film solar cells faster and more economically than current equipment. Systems of the disclosure incorporate configuration flexibility that can accommodate the deposition of different layers of a thin film solar cell.

An aspect of the present disclosure provides a deposition system for depositing a thin film photovoltaic cell on a flexible substrate. The deposition system comprises an enclosure comprising a fluid space that is fluidically isolated from an environment external to the enclosure, and a plurality of deposition chambers in the fluid space. At least one deposition chamber of the plurality of deposition chambers comprises a magnetron sputtering apparatus that directs a material flux of one or more target materials towards a portion of the flexible substrate that is disposed in the at least one deposition chamber of the plurality of deposition chambers. Each of said deposition chambers that comprises a magnetron sputtering apparatus includes openings through which said flexible substrate passes and adjustable conductance limiters arranged at said openings to form a gap between said substrate and said conductance limiter. The deposition system further comprises a substrate payout roller and a substrate take-up roller in the enclosure. The substrate payout roller provides a flexible substrate that is directed through each of the plurality of deposition chambers to the substrate take-up roller. The deposition system comprises at least one guide roller in the enclosure. The guide roller is configured to direct the flexible substrate to or from a given deposition chamber among the plurality of deposition chambers. The said at least one deposition chamber comprises a magnetron sputtering apparatus comprising: a rotatable magnetron adjacent to a planar magnetron; and one or more shields forming a sub-chamber between said rotatable magnetron and said planar magnetron, wherein said planar magnetron is configured to contain a liquid target having a first material and provide a material flux having said first material towards said rotatable magnetron, and wherein said rotatable magnetron is configured to rotate a solid target having a second material in relation to said planar magnetron and provide a material flux having said first and second materials towards said flexible substrate.

Another aspect of the present disclosure provides a deposition system for depositing a thin film photovoltaic cell on a flexible substrate. The deposition system comprises an enclosure comprising a fluid space that is fluidically isolated from an environment external to the enclosure, and a plurality of deposition chambers in the fluid space. The plurality of deposition chambers comprises a first deposition chamber and a second deposition chamber. The first deposition chamber comprises a magnetron sputtering apparatus that directs a first material flux towards a first side of a portion of the flexible substrate. The second deposition chamber comprises a magnetron sputtering apparatus that directs a second material flux towards a second side of the portion that is opposite from the first side. Each of said first and second deposition chambers includes openings through which said flexible substrate passes and adjustable conductance limiters arranged at said openings to form a gap between said substrate and said conductance limiter. The deposition system further comprises a payout roller and a take-up roller in the enclosure. The payout roller sequentially directs the flexible substrate to the take-up roller through each of the plurality of deposition chambers. At least one of said plurality of deposition chambers comprises a magnetron sputtering apparatus comprising: a rotatable magnetron sputtering apparatus adjacent to a planar magnetron sputtering apparatus; and one or more shields forming a sub-chamber between said rotatable magnetron sputtering apparatus and said planar magnetron sputtering apparatus, wherein said planar magnetron sputtering apparatus is configured to contain a liquid target having a first material and provide a material flux having said first material towards said rotatable magnetron, and wherein said rotatable magnetron sputtering apparatus is configured to rotate a solid target having a second material in relation to said planar magnetron sputtering apparatus and provide a material flux having said first and second materials towards said flexible substrate.

Another aspect of the present disclosure provides a method for depositing a photovoltaic cell device structure adjacent to a flexible substrate, comprising providing a deposition system comprising a plurality of deposition chambers in a sealed enclosure. At least one deposition chamber of the plurality of deposition chambers can comprise a magnetron sputtering apparatus that directs a material flux of one or more target materials towards a portion of the flexible substrate that is disposed in the at least one deposition chamber. The deposition system can

EP - 13738253.7 - 74553-EP-EPT - P18835EP-W - Amended Description - March 2016 further comprise a payout roller and a take-up roller in the enclosure, and at least one guide roller for directing the flexible substrate to or from a given deposition chamber among the plurality. Next, with the aid of the at least one guide roller, the flexible substrate can be directed from the payout roller through each of the plurality of deposition chambers in sequence to form the photovoltaic cell device structure adjacent to the flexible substrate. The flexible substrate can then be directed from the plurality of deposition chambers to the take-up roller.

Additional aspects and advantages of the present disclosure will become readily apparent to those skilled in this art from the following detailed description, wherein only illustrative embodiments of the present disclosure are shown and described. As will be realized, the present disclosure is capable of other and different embodiments, and its several details are capable of modifications in various obvious respects, all without departing from the disclosure. Accordingly, the drawings and description are to be regarded as illustrative in nature, and not as restrictive.

### BRIEF DESCRIPTION OF THE DRAWINGS

The novel features of the invention are set forth with particularity in the appended claims. A better understanding of the features and advantages of the present invention will be obtained by reference to the following detailed description that sets forth illustrative embodiments, in which the principles of the invention are utilized, and the accompanying drawings of which:
**FIG. 1** is an overall three-dimensional perspective view of the coating apparatus of the current invention.
**FIG. 2** is a perspective cross sectional diagram showing the interior details of the coating apparatus of the current invention.
**FIG. 3** is a simplified planar cross sectional diagram limited to showing only the major design elements of the coating apparatus of the current invention.
**FIG. 4** is a cross sectional schematic diagram of a typical coating station of FIG. 3 showing the detailed configuration for one basic embodiment of a deposition chamber of the current invention.
**FIG. 5** is a combinational, cross sectional schematic diagram illustrating details for the additional coating configurations of the deposition chamber of the present invention.
**FIG. 6** is a combinational, cross sectional schematic diagram showing a conventional drum and transport system embodiment for the various coating configurations of the deposition chamber of this invention.
**FIG. 7** shows a cross sectional diagram of the coating machine of the present invention fully configured in the more conventional coating drum embodiment.
**FIG. 8** shows a cross sectional schematic view of the coating machine of the present invention when configured for coating the back electrode for a CIGS type thin film solar cell on a thin metal foil substrate.
**FIG. 9** shows a cross sectional schematic view of the coating machine of the present invention when configured for coating the absorber layer for a CIGS type solar cell on a thin metal foil substrate.
**FIG. 10** shows a cross sectional schematic view of the coating machine of the present invention when configured for coating the junction layer for a CIGS type solar cell on a thin metal foil substrate.
**FIG. 11** shows a cross sectional schematic view of the coating machine of the present invention when configured for coating the transparent top electrode for a CIGS type solar cell on a thin metal foil substrate.
**FIG. 12** shows a cross sectional schematic view of the coating machine of the present invention when configured to avoid transport roller contact with the coated surface of the web.
**FIG. 13** shows a cross sectional schematic view of the coating machine of the present invention with an alternative configuration which avoids transport roller contact with the coated surface of the web until the coating is completed.
**FIG. 14** schematically illustrates a computer system that is programmed or otherwise configured to implement the methods of the disclosure.

### DETAILED DESCRIPTION

While various embodiments of the invention(s) of the present disclosure have been shown and described herein, it will be obvious to those skilled in the art that such embodiments are provided by way of example only. Numerous variations, changes, and substitutions may occur to those skilled in the art without departing from the invention(s). It should be understood that various alternatives to the embodiments of the invention(s) described herein may be employed in practicing any one of the inventions(s) set forth herein.

The term "photovoltaic cell" or "solar cell," as used herein, refers to a solid state electrical device having an active material (or absorber) that converts the energy of electromagnetic radiation (or light) into electricity by the photovoltaic (PV) effect.

The term "absorber," as used herein, generally refers to a photoactive material that, upon exposure to electromagnetic radiation, converts the energy of electromagnetic radiation into electricity by the photovoltaic (PV) effect. An absorber can be configured to generate electricity at select wavelengths of light. An absorber layer can be configured to generate electron / hole pairs. Upon exposure to light, an absorber can generate electron / hole pairs. Examples of absorbers include, without limitation, copper indium gallium di-selenide (CIGS) and copper indium selenide (CIS). An absorber layer can be doped n-type or p-type. Some absorbers are n-type or p-type without any additional doping. For example, CIGS, as formed, can be p-type and may not require any additional p-type doping. In some cases, upon formation of the absorber layer (e.g., silicon absorber layer), a precursor of an n-type or p-type dopant is introduced for incorporating the n-type or p-type dopant into the absorber layer. As an alternative, following formation of the absorber layer, the n-type or p-type dopant can be introduced into the absorber layer by ion implantation followed by annealing. In some situations (e.g., CIGS), a sodium precursor is provided to the absorber layer to include sodium in the absorber layer.

The term "photovoltaic module" or "solar module," as used herein, refers to a packaged array of one or more PV cells. The PV module (also "module" herein) can be used as a component of a larger photovoltaic system to generate and supply electricity, such as in commercial and residential applications. A PV module can include a support structure having one or more PV cells. In some embodiments, a PV module includes a plurality of PV cells, which can be interconnected, such as, for example, in series with the aid of interconnects. A PV array can include a plurality of PV modules.

The term "n-type," as used herein, generally refers to a material that is chemically doped ("doped") with an n-type dopant. For instance, silicon can be doped n-type using phosphorous or arsenic.

The term "p-type," as used herein, generally refers to a material that is doped with an p-type dopant. For instance, silicon can be doped p-type using boron or aluminum.

The term "layer," as used herein, generally refers to a layer of atoms or molecules on a substrate. In some cases, a layer includes an epitaxial layer or a plurality of epitaxial layers. A layer may include a film or thin film. In some situations, a layer is a structural component of a device (e.g., light emitting diode) serving a predetermined device function, such as, for example, an active layer that is configured to generate (or emit) light. A layer generally has a thickness from about one monolayer (ML) to tens of monolayers, hundreds of monolayers, thousands of monolayers, millions of monolayers, billions of monolayers, trillions of monolayers, or more. In an example, a layer is a multilayer structure having a thickness greater than one monolayer. In addition, a layer may include multiple material layers (or sub-layers). In an example, a multiple quantum well active layer includes multiple well and barrier layers. A layer may include a plurality of sub-layers. For example, an active layer may include a barrier sub-layer and a well sub-layer.

The term "substrate," as used herein, generally refers to any workpiece on which a layer, film or thin film formation is desired. A substrate includes, without limitation, silicon, germanium, silica, sapphire, zinc oxide, carbon (e.g., graphene), SiC, AlN, GaN, spinel, coated silicon, silicon on oxide, silicon carbide on oxide, glass, gallium nitride, indium nitride, titanium dioxide and aluminum nitride, a ceramic material (e.g., alumina, AlN), a metallic material (e.g., stainless steel, tungsten, titanium, copper, aluminum), a polymeric material and combinations (or alloys) thereof.

The term "adjacent" or "adjacent to," as used herein, includes 'next to', 'adjoining', 'in contact with', and 'in proximity to'. In some instances, adjacent to components are separated from one another by one or more intervening layers. For example, the one or more intervening layers can have a thickness less than about 10 micrometers ("microns"), 1 micron, 500 nanometers ("nm"), 100 nm, 50 nm, 10 nm, 1 nm, or less. In an example, a first layer is adjacent to a second layer when the first layer is in direct contact with the second layer. In another example, a first layer is adjacent to a second layer when the first layer is separated from the second layer by a third layer.

The term "reaction space," as used herein, generally refers to any environment suitable for depositing a material layer, film or thin film adjacent to a substrate, or the measurement of the physical characteristics of the material layer, film or thin film. A reaction space can include or be fluidically coupled to a material source. In an example, a reaction space includes a reaction chamber (also "chamber" herein). In another example, a reaction space includes a chamber in a system having a plurality chambers. A reaction space may include a chamber in a system having a plurality of fluidically separated chambers. A system for forming a photovoltaic cell can include multiple reactions spaces. Reactions spaces can be fluidically separated from one another. Some reaction spaces can be suitable for conducting measurements on a substrate or a layer, film or thin film formed adjacent to the substrate.

The term "fluid space," as used herein, generally refers to any environment that can contain a fluid or direct a fluid along a fluid flow path. In some cases, a fluid space is a reaction space.

The term "flux," as used herein, generally refers to the flow of a material. Flux in some cases is the flow rate of a material per unit area.

### Sputtering systems

An aspect of the disclosure provides deposition systems for depositing a thin film photovoltaic cell on a flexible substrate. Such systems can be employed for use for forming photovoltaic cells comprising an absorber formed of copper indium gallium diselenide (CIGS), copper indium aluminum diselenide (CIAS), copper zinc tin disulfide/selenide (CZTS), copper indium diselenide (CIS), cadmium tellurium ("cadmium telluride"), or cadmium zinc tellurium.

A system for depositing a photovoltaic cell on a flexible substrate comprises an enclosure comprising a fluid space that is fluidically isolated from an environment external to the enclosure, and a plurality of deposition chambers in the fluid space. At least one deposition chamber of the plurality of deposition chambers comprises a magnetron sputtering assembly (or apparatus) (also "magnetron" herein) that directs a material flux of one or more target materials towards a portion of the flexible substrate that is disposed in the at least one deposition chamber of the plurality of deposition chambers. The system can further include at least one guide roller in the fluid space of enclosure. The guide roller can be configured to direct the flexible substrate to or from a given deposition chamber among the plurality of deposition chambers.

A deposition chamber can include one or more walls that contain a reaction space. The deposition chamber may have an opening for permitting a material flux to come in contact with the flexible substrate.

A guide roller can be disposed between a first deposition chamber and a second deposition chamber among the plurality of deposition chambers. The guide roller can be used to guide or otherwise direct the flexible substrate from the first deposition chamber to the second deposition chamber. The guide roller can be fluidically isolated from the first and second deposition chambers. The guide roller can be disposed in the fluid space.

A guide roller can direct or otherwise guide a flexible substrate from a substrate payout roller to a deposition chamber, from a deposition chamber to a substrate take-up roller, or from one deposition chamber to another deposition chamber among the plurality of deposition chambers. The payout roller can include a roll of a flexible substrate that is directed into one or more deposition chambers. The substrate can be wrapped (or wound) around a spool of the payout roller. Following film deposition, the substrate is directed into the take-up roller. The substrate can be directed into and wrapped (or wound) around a spool of the take-up roller.

A guide roller can be fluidically isolated from the first and second deposition chambers with the aid of a purge gas or other background gas that minimizes, or prevents, a gas or vapor from the deposition chambers from coming in contact with the roller.

The system can include at least 1, 2, 3, 4, 5, 6, 7, 8, 9, 10, 20, 30, 40, 50, 100, or 1000 guide rollers. The system can include at least 1, 2, 3, 4, 5, 6, 7, 8, 9, 10, 20, 30, 40, 50, or 100 guide rollers in between individual deposition chambers in the enclosure.

In some situations, the use of guide rollers can preclude the need for a drum to direct a flexible substrate among deposition chambers. This can advantageously aid in minimizing system complexity, which can aid in minimizing cost. In some examples, the system is drum less (i.e., not comprising a drum). In some implementations, the use of rollers (as opposed to a drum) can decouple (e.g., thermally decouple) deposition chambers (and portions or the substrate in each deposition chamber), which can enable various benefits and advantages. For example, the use of rollers as opposed to a drum can enable, for example, 1) simultaneous back side and front side coating of a substrate, which can provide for faster photovoltaic cell fabrication, 2) more rapid heating / cooling and higher heating rates, and 3) independent heating at various deposition chambers, which can provide for different temperatures and heating / cooling rates.

In some examples, the deposition chambers in the enclosure can be fluidically isolated from one another with the aid of a purge gas or other background gas that fills the enclosure. As an alternative, or in addition to, the enclosure can include a pumping system that pumps away a gas or vapor that flows from a deposition chamber into the fluid space.

The pumping system can include one or more vacuum pumps, such as one or more of a turbomolecular ("turbo") pump, a diffusion pump, ion pump, cryogenic ("cryo") pump, and a mechanical pump. A pump can include one or more backing pumps. For example, a turbo pump may be backed by a mechanical pump.

The system can further include a substrate payout roller (also "payout roller" herein) and a substrate take-up roller (also "take-up roller" herein) in the enclosure. During use, the flexible substrate is directed from the payout roller through each of the plurality of deposition chambers to the take-up roller.

The system can further include one or more additional deposition chambers that do not include magnetron sputtering assemblies (or apparatuses). The flexible substrate can be directed from the payout roller through the one or more additional deposition chambers to the take-up roller.

The enclosure can have various shapes and sizes. In some examples, the enclosure has a circular, triangular, square or rectangular cross-section. In an example, the enclosure is generally cylindrical in shape.

The enclosure can be formed of a metallic material, such as stainless steel. The enclosure can have a length from about 1 foot (0.3 m) to 100 feet (30 m), or 1 foot (0.3 m) to 10 feet (3 m), and a diameter (or width) from about 1 foot (0.3 m) to 100 feet (30 m), or 1 foot (0.3 m) to 10 feet (3 m). The enclosure can include a cap that seals the enclosure during system operation. The fluid space can be maintained at a given pressure with the aid of a pumping system in fluid communication with the fluid space.

For instance, the enclosure can be maintained under vacuum or in a controlled environment. The enclosure can be maintained under vacuum with the aid of a pumping system, as described elsewhere herein. In some situations, the enclosure is purged with a gas (e.g., Ar, He, Ne, N₂).

In some example, the enclosure is maintained under vacuum with the aid of a pumping system. The enclosure can be maintained at a pressure that is less than or equal to about 100 torr, 1 torr, 10⁻¹ torr, 10⁻² torr, 10⁻³ torr, 10⁻⁴ torr, 10⁻⁵ torr, 10⁻⁶ torr, 10⁻⁷ torr, or 10⁻⁸ torr. As an alternative, the enclosure is maintained at a pressure that is elevated with respect to a pressure of an environment external to the enclosure. For example, the enclosure can be maintained at a pressure greater than or equal to about 10⁻⁶ torr, 10⁻⁵ torr, 10⁻⁴ torr, 10⁻³ torr, 10⁻² torr, 10⁻¹ torr, 1 torr, 100 torr, or 1000 torr.

The flexible substrate can be directed from one deposition chamber to another with the aid of a substrate web that supports the substrate. The substrate web can be configured to hold the substrate. In an example, the substrate web is a mesh.

The flexible substrate can be formed of various types of materials. In some cases, the flexible substrate is formed of an electrically conductive material. In an example, the flexible substrate is a stainless steel substrate. In another example, the flexible substrate is an aluminum substrate. In another example, the flexible substrate is formed of a polymeric material.

An individual chamber of the plurality of chambers of the system can include a first opening for permitting the flexible substrate to enter the individual chamber and a second opening for permitting the web to exit the individual chamber. The first and second openings are adapted to permit the flexible substrate to pass through the openings. The first and second openings can have various shapes and or sizes. In some examples, the openings are slits. The system can include a first roller adjacent to the first opening and a second roller adjacent to the second opening. The first roller is configured to direct the flexible substrate into the individual chamber and the second roller is configured to direct the flexible substrate out of the individual chamber.

The plurality of deposition chambers can include a plurality of magnetron sputtering assemblies. An individual magnetron sputtering assembly (or apparatus) can be disposed in an individual deposition chamber of the plurality of deposition chambers. In some cases, a deposition chamber includes a plurality of magnetron sputtering assemblies. For instance, a deposition chamber can include at least 1, 2, 3, 4, 5, 6, 7, 8, 9, 10, 20, 30, 40, 50, or 100 magnetron sputtering assemblies, each of which can be configured to provide a flux of one or more target materials. A magnetron sputtering assembly can be a rotatable magnetron or a planar magnetron. A planar magnetron can have a horizontal configuration.

A system can include one or more deposition chambers. In some cases, a system comprising an enclosure housing at least 1, 2, 3, 4, 5, 6, 7, 8, 9, 10, 20, 30, 40, 50, or 100 deposition chambers. The system can include a substrate payout roller for providing (e.g., feeding out) a substrate, and a substrate take-up roller for taking up the substrate following the deposition of one or more material layers in the deposition chambers of the system.

Photovoltaic cell layers can be deposited sequentially-i.e., one after the other. This can be accomplished by directing a portion of the substrate into deposition chambers sequentially.

The system in some cases includes at least one deposition chamber that comprises a plurality of magnetron sputtering assemblies. In some examples, the at least one deposition chamber includes a plurality of planar magnetron sputtering assemblies, a plurality of rotatable magnetron sputtering assemblies, or a combination of planar and rotatable magnetron sputtering assemblies.

In some examples, the system is configured for forming a silicon, CIGS, CIS, CIAS, CZTS, CdTe or CdZnTe absorber adjacent to the substrate. In such cases, a deposition chamber of the system can be configured to provide a material flux of copper, indium and gallium. The deposition chamber can provide a material flux of selenium, in some cases separately from the other material fluxes.

During use, the flexible substrate is directed into an individual deposition chamber and a portion of the flexible substrate that is in the deposition chamber is exposed to a material flux of one or more target materials. The flexible substrate can move through a deposition chamber at a continuous rate, such as at a rate of at least about 0.001 meters (m) / minute (min), 0.01 m/min, 0.1 m/min, 1 m/min, 10 m/min, or 100 m/min, or, as an alternative, in a series of steps.

One or more magnetron sputtering assemblies can be configured to provide a material flux from a liquid target. In some situations, at least one of the at least the subset of the plurality of deposition chambers of the system comprises a magnetron sputtering assembly comprising a rotatable magnetron sputtering apparatus adjacent to a planar magnetron sputtering apparatus, and one or more shields forming a sub-chamber between the rotatable magnetron sputtering apparatus and the planar magnetron sputtering apparatus. The planar magnetron sputtering apparatus can be configured to contain a liquid target having a first material and provide a material flux having the first material towards the rotatable magnetron sputtering apparatus. The rotatable magnetron sputtering apparatus can be configured to rotate a solid target having a second material in relation to the planar magnetron sputtering apparatus and provide a material flux having the first and second materials towards the flexible substrate. The first material can have a first melting point that is lower than a second melting point of the second material. In an example, the first material is gallium and the second material is indium. The planar magnetron sputtering apparatus can be configured to provide a flux of the first material in the sub-chamber.

In some cases, another planar magnetron sputtering apparatus can be provided adjacent to the planar magnetron sputtering apparatus. The other planar magnetron sputtering apparatus can be configured to provide a flux of a third material in the sub-chamber. The flux of the third material can be directed towards the rotatable magnetron sputtering apparatus.

The rotatable magnetron sputtering apparatus can be at least partly cylindrical in shape. In some cases, the rotatable magnetron sputtering apparatus is substantially cylindrical in shape. The planar magnetron sputtering apparatus can include a backing plate that is adjacent to a magnetron sputtering apparatus body. The magnetron sputtering apparatus body can include one or more magnets and the backing plate that is adapted to hold the liquid target.

In some cases, the rotatable magnetron sputtering apparatus can comprise a support member adapted to rotate the solid target in relation to the planar magnetron sputtering apparatus. The planar magnetron sputtering apparatus can be adapted to contain another liquid having a third material.

A deposition chamber can include multiple magnetron sputtering assemblies. In some cases, individual magnetron sputtering assemblies of a deposition chamber can be configured to provide a material flux towards the flexible substrate.

Magnetron sputtering assemblies can be situated in sub-chambers (i.e., chamber or enclosure within a deposition chamber) of deposition chambers. In an example, a magnetron sputtering assembly is enclosed in a sub-chamber having an opening adapted to expose the substrate to a material flux from the magnetron sputtering assembly.

A deposition chamber can include sources of other materials. Such source of other material may be magnetron sputtering assemblies or other types of deposition apparatuses. For instance, the system can include one or more additional deposition chambers that do not include magnetron sputtering apparatuses. In some cases, a source of a material is a vapor source that is provided into the deposition chamber through a fluid flow path that is in fluid communication with a liquid containing the material. In an example, selenium or sulfur vapor is provided into a deposition chamber through a fluid flow path that is in fluid communication with a liquid comprising selenium or sulfur.

Although a flexible substrate is used in the various examples and configurations provided herein, as an alternative, a non-flexible (e.g., glass slide) or substantially rigid substrate may be used. Payout and take-up rollers may be precluded in the case of a non-flexible substrate.

A system can include one or more deposition chambers in an enclosure (or chamber). In an example, an enclosure or all-encompassing chamber houses separate deposition chambers. The enclosure can be sealed from an environment external to the enclosure. An individual deposition chamber of the system can include one or more magnetron sputtering assemblies, each of which can be contained in a sub-chamber of the deposition chamber. In some cases, the system comprises an enclosure that is a chamber, and the enclosure houses separate deposition systems, which may be referred to as sub-chambers.

The system can include a deposition chamber comprising a magnetron sputtering apparatus that directs a material flux of one or more target materials to a back side of a flexible substrate. The system can include a deposition chamber comprising a first magnetron sputtering apparatus that directs a first material flux towards a front side of the flexible substrate, and a second magnetron sputtering apparatus that directs a second material flux towards a back side of the flexible substrate. The front side and back side can be opposite from one another.

For example, a deposition chamber among the plurality of deposition chambers of the system can include a first magnetron sputtering apparatus situated such that it faces a front side of a flexible substrate, and a second magnetron sputtering apparatus situated such that it faces a back side of the flexible substrate. The first magnetron sputtering apparatus can be configured to provide a material flux of target materials to form an absorber layer adjacent to the front side of a flexible substrate. The second magnetron sputtering apparatus can provide a material flux of a back electrode material (e.g., molybdenum, niobium, or tantalum) to the back side of the flexible substrate to form a back electrode adjacent to the flexible substrate.

As another example, the system can include a deposition system for depositing a thin film photovoltaic cell on a flexible substrate comprises an enclosure comprising a fluid space that is fluidically isolated from an environment external to the enclosure, and a plurality of deposition chambers in the fluid space. The plurality of deposition chambers comprises a first deposition chamber and a second deposition chamber. The first deposition chamber comprises a magnetron sputtering apparatus that directs a first material flux towards a first side of a portion of the flexible substrate. The second deposition chamber comprises a magnetron sputtering apparatus that directs a second material flux towards a second side of the portion that is opposite from the first side. A payout roller sequentially directs the flexible substrate through each of the plurality of deposition chambers to a take-up roller. The system can include one or more guide rollers for guiding or otherwise directing the flexible substrate to and through the deposition chambers.

In some cases, the first deposition chamber is disposed adjacent to the second deposition chamber. In an example, the first and second deposition chambers can be situated substantially adjacent one another such that the first material flux and second material flux are directed towards the first side and second side, respectively. In some cases, the first material flux and the second material flux are directed toward the first side and the second side at substantially the same time.

Another aspect of the present disclosure provides a method for forming a photovoltaic cell device structure adjacent to a flexible substrate. The method can comprise providing a deposition system comprising a plurality of deposition chambers in a sealed enclosure. The deposition system can be as described above or elsewhere herein. For example, the deposition system can include at least one deposition chamber that includes a magnetron sputtering apparatus that directs a material flux of one or more target materials towards a portion of the flexible substrate that is disposed in the at least one deposition chamber. The deposition system comprises a payout roller and a take-up roller in the enclosure. The payout roller provides the flexible substrate.

Next, the flexible substrate is directed from the payout roller through each of the plurality of deposition chambers in sequence to form the photovoltaic cell device structure adjacent to the flexible substrate. The flexible substrate can be directed through each of the plurality of deposition chambers upon the rotation of the payout and take-up rollers, which may be facilitated with the aid of one or more motors and regulated with the aid of a controller (see below). The flexible substrate is directed from the plurality of deposition chambers to the take-up roller.

In an example, the deposition system comprises six deposition chambers, a payout roller upstream of the deposition chambers, and a take-up roller downstream of the deposition chambers. The flexible substrate is directed from the payout roller through each individual deposition chamber in sequence, and from a last of the deposition chambers to the take-up roller, where the flexible substrate with photovoltaic device structure formed thereon is collected.

In some cases, the flexible substrate can be directed along at least one roller that is disposed between a first deposition chamber and a second deposition chamber of the plurality of deposition chambers. The flexible substrate can be directed along at least 1, 2, 3, 4, 5, 6, 7, 8, 9, 10, 20, 30, 40, 50, or 100 rollers.

A photovoltaic manufacturing system can include multiple systems. Each system can be as described above or elsewhere herein. A given system can be dedicated for use in forming a given PV device structure (e.g., absorber). During use, a user may provide a payout roller comprising a flexible substrate in a first system, process the flexible substrate to include a given device structure and collect the flexible substrate on the take-up roller, remove the take-up roller from the first system, and install the take-up roller as a payout roller of a second system for further PV processing.

A PV manufacturing system can include at least 1, 2, 3, 4, 5, 6, 7, 8, 9, 10, 20, 30, 40, or 50 separate systems, each comprising an enclosure that comprises a plurality of deposition chambers, as described elsewhere herein.

Reference will now be made to the figures, wherein like numerals refer to like parts throughout. It will be appreciated that the figures (and features therein) are not necessarily drawn to scale.

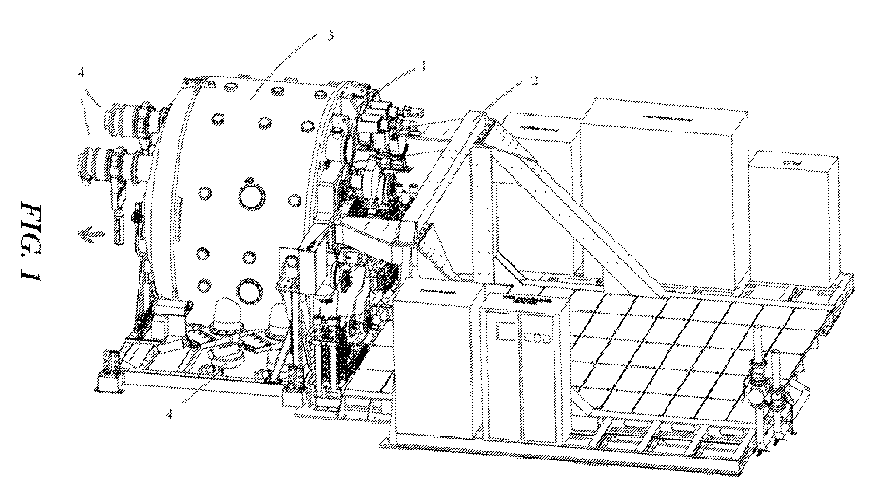

An overall three dimensional perspective view of a deposition system (or machine) is shown in FIG. 1. The primary elements of the machine include a massive heavily braced steel back plate 1 which is supported in a vertical position by heavy framing 2 tied into a concrete floor. All of the coating equipment, the rolls of substrate, and the substrate transport apparatus are mounted on the braced back plate. A large cylindrical cover enclosure 3 forms a vacuum seal with the back plate, but can be rolled away (details not shown) in the direction of the arrow to expose the roll coating apparatus for target changes, substrate changes, and other maintenance functions. Large turbo molecular pumps 4 can be arrayed around the enclosure 3. They maintain the high vacuum levels required during coating operations. Various cabinets arrayed around the support structure house the typical equipment required for vacuum deposition machine function. These include computers and control electronics as well as sputtering power supplies, pump controllers, and web drive controllers to mention but a few. As an indication of scale, enclosure 3 has a diameter of about 13 feet (4 m), while its length accommodates a web coating width of about a meter. The machine design is not fundamentally restricted to a meter coating width; rather, that is currently the widest availability of suitable metal foil substrates.

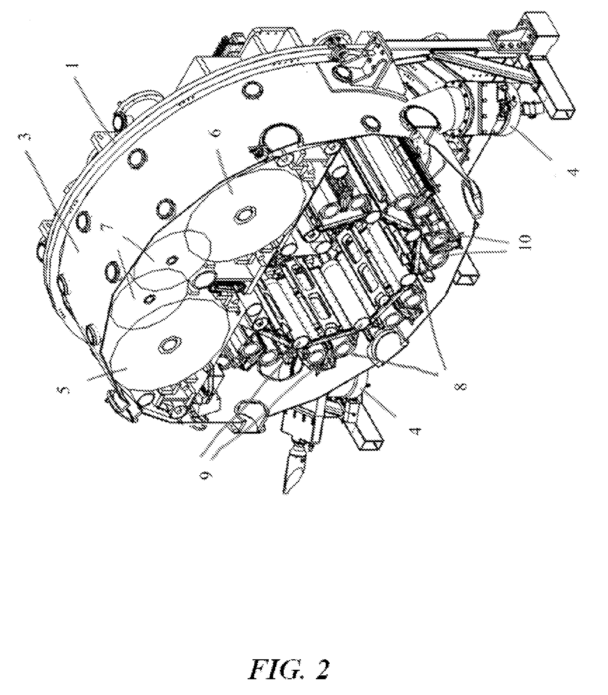

**FIG. 2** shows a cross-section of the system of **FIG. 1** in three-dimensional perspective view. The cross section is taken through enclosure 3 near its closed end with the view looking toward the back plate 1. Many details of the interior of the machine are revealed in the figure. Some of the major components of the machine can be readily identified. An upper section of the systems comprises a large pay out (or payout) roll 5 and take-up (or uptake, pickup) roll 6 for the flexible foil substrate. Rolls 7 are available for interleaving the substrate rolls with a thin web of material to protect coating layers that may require it. The lower section contains the coating hardware and components of the web handling system. In the illustrated example there are six chambers 8 arrayed in circular fashion between guide rollers 9. The guide rollers 9 can be web transport rollers. The other guide rollers are not specifically labeled in this figure. Each chamber 8 contains a pair of rotatable magnetrons 10 which hold and sputter the target material that produces a desired or otherwise predetermined coating. The target material in the various chambers may all be alike, or, at least some may be different. In some cases, all of the target materials are different. The target materials may be different within a given deposition chamber. Thus this flexibility in target setup provides a large amount of selectable variation in coating design.

A photovoltaic manufacturing system can include multiple systems, such as that illustrated in **FIGs. 1** and **2****.** An individual system can be configured to deposit one or more material layers of a photovoltaic cell. For example, the system of **FIGs. 1** and **2** can be configured to form an absorber layer or stack of the photovoltaic cell.

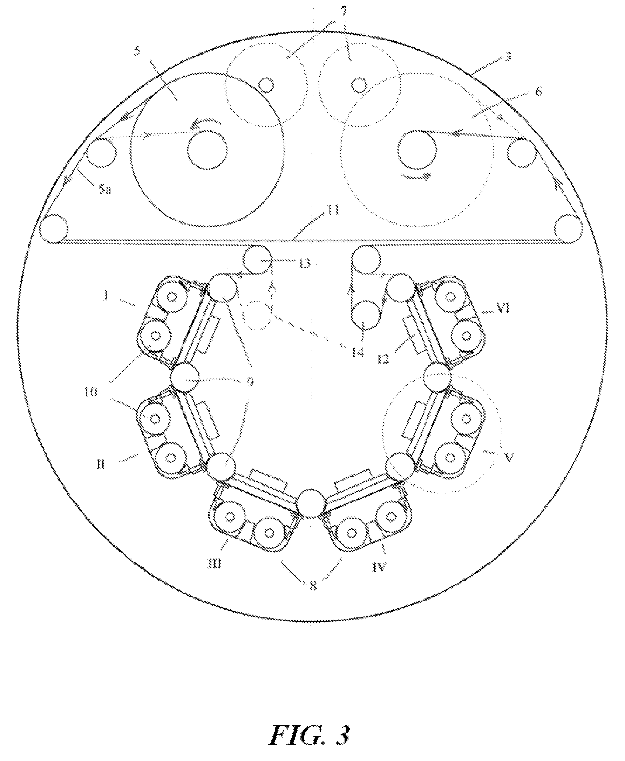

**FIG. 3** is a planar cross sectional sketch of the coating machine representing the primary elements of **FIG. 2****.** Also shown in this figure is a thin sheet metal dividing plate 11 that forms a significant vapor barrier between the upper and lower sections of the machine. Often rolls of substrate can contain variable amounts of water vapor or other volatile materials that are best exposed to the vacuum and pumped away before they can contaminate the coating region. Another feature in this figure is the apparatus 12 shown facing the back side of the substrate opposite to each chamber. The apparatus 12 can provide substrate heating or cooling at that particular coating station. Substrate heating and/or cooling can be with the aid of radiative heat transfer.

Still referring to **FIG. 3****,** a web transport layout is indicated in solid lines with arrows indicating the web 5a and its transport direction. A large roll of substrate 5 pays out in the direction indicated by the arrows. If it contains a protective interleaf material, that material is wound up on roll 7 simultaneous with the pay out. The web proceeds around a couple of guide or idle rollers and passes under barrier 11 before reaching roller 13, which can be equipped with a load cell to measure tension in the web. From there the web is transported through the coating region around a set of idle rollers 9. At this machine scale there are six coating stations which, for convenience of referencing, are labeled by Roman numerals I through VI in the direction of web transport. Roller 14 can be used in concert with the last roller 9 to form an "S" wrap. This allows roller 14 to have sufficient friction with the web to be driven to produce and maintain the necessary tension in the web for proper handling. From here the web proceeds around guide rollers to reach take up roll 6 where an interleaf layer from roll 7 can be inserted if required. The web transport system can be totally reversed as indicated by the dashed transport and roller identification lines. While the coating region is shown consisting of six dual rotatable magnetron sputtering stations from I-VI, this is not a fundamental limitation of the invention, but rather a practical arrangement given the size of the machine and the common industrial size of the rotatable magnetrons. A smaller system can have fewer sputtering stations, while a larger system can have more.

The arrangement of rollers 9 in **FIG. 3** permits the coatings at each station to be provided in "free span" mode. This method can allow independent heating or cooling of the web (and substrate) to be done at any of the coating stations, and other web backside operations also can be accomplished. The free span design can be used for solar cell coatings. In some cases, a more conventional drum can be used in place of the set of free span rollers. This alternative, in some cases, may be suitable for films deposited on polymeric substrates which can be kept cool during exposure to the coating sources. A description of the drum is provided below. An example deposition station as indicated in the dashed circle is enlarged and described in more detail in the next figure.

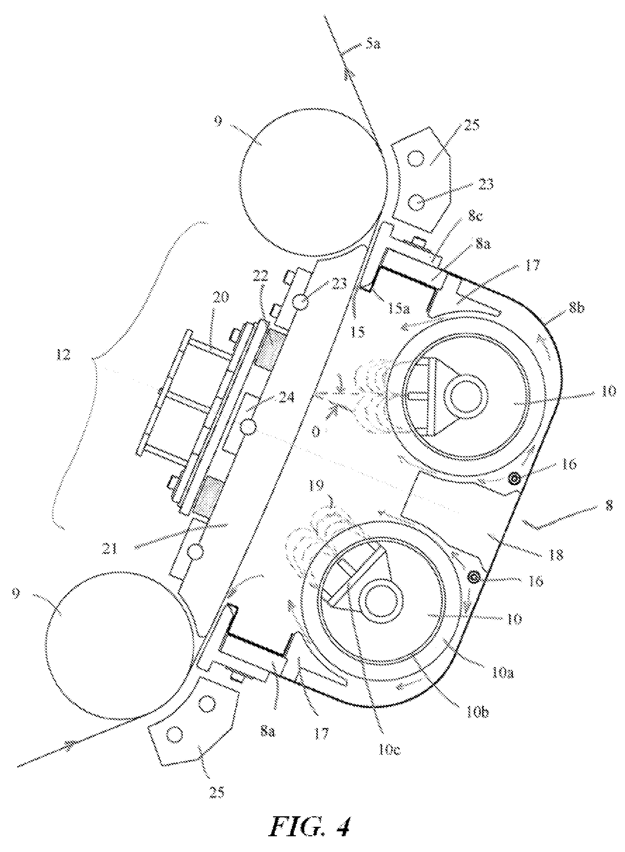

**FIG. 4** is an enlarged cross sectional schematic diagram of a typical coating station as indicated in **FIG. 3****.** It illustrates in more detail the chamber configuration for the basic operation of sputtering pure metals or metal alloys using dual rotatable magnetrons. For photovoltaic (or solar) cells, the elements of the cross section generally have lengths of slightly more than a meter, appropriate for deposition on a flexible metallic web that is a meter wide. Currently, thin flexible metallic webs with adequate surface finish are not available in wider formats, but fundamentally the width of the machine is not limited only to a meter.
With reference to **FIG. 4****,** chamber 8 comprises two support bars 8a with an attached enclosure 8b formed from relatively thick stainless steel sheet metal. This type of chamber construction is not functionally required by the invention, but it is less massive than an alternative structure made from metal plates similar to that shown in **FIG. 2b.** The conductance of sputtering gases from inside the chamber out to the large vacuum chamber is regulated by conduction limiters 8c. They are adjustable, by screws in slotted holes, to create a small gap 15 between substrate 5a and conduction limiter 8c. The width of this small gap is nominally in the range of several hundredths of an inch up to an eighth of an inch (0.32 cm) or more, depending upon the sputtering pressure and gas flow in the chamber that is appropriate for the particular process selected for that station. The chamber can enable a locally higher pressure in the sputtering region while a lower pressure is maintained outside. It also provides sufficient gas separation between chambers so that different processes may be run in adjacent sputtering zones. Replaceable shields 15a collect the high angle sputtered flux that can otherwise coat the more permanent components of the chamber.

Sputtering gas (e.g., argon) and reactive gases are introduced into the chamber through two long tubes 16 which have an array of small holes all along their length. The gases flow around rotatable magnetrons 10 as suggested by the arrows. The gases are made to travel near the surface of the magnetrons by flow restrictors 17 at each side and 18 in the middle between the magnetrons. The restrictors may be made from aluminum, but they need not be solid in cross section. When sputtering using direct current (DC) power, they may conveniently do double duty by becoming the electrical anode for the plasma which is produced by magnetrons 10.

Rotatable magnetrons may be purchased from a number of commercial vendors, but they all share some common basic features. For instance magnetron 10 has a target material 10a, a backing tube 10b that holds the target material, and a magnetic array 10c for producing magnetic fields 19. The backing tube may be eliminated for target materials that have sufficient strength to be made in monolithic tubular form. The magnetic fields trap electrons in the plasma which allows the plasma to be maintained at low sputtering pressures. The magnetic array can be oriented at a convenient angle θ with respect to the substrate. The rotatable magnetrons may also include various improvements in structure and operation of the magnetic array which provides increased target utilization. An example improvement is fully described in U.S. Patent Application No. 12/753,814 and Patent Cooperation Treaty (PCT) Patent Application No. PCT/US2011/030793, each of which is entirely incorporated herein by reference.

With continued reference to **FIG. 4****,** the heater or cooler 12 of **FIG. 3** is illustrated in greater detail. Shown here as a heater, it consists of a support structure 20 which carries a thermally conducting plate 21 held on thermal insulators 22. The heating function is supplied by rod heaters 23 held to the plate by clamps 24. The rod heaters may be replaced by tubes carrying chilled water (not shown) to convert the structure to a substrate cooling unit. The surface of plate 21 which faces the back of substrate 5a is slightly curved to cause the substrate to maintain sliding contact with the plate as it is transported through the opening in the chamber to receive the coating. If the sliding contact is not desired, the surface of the plate can be made flat and positioned a small distance away from the substrate (not shown). In this case substrate heating or cooling occurs only by radiation transport, but that is sufficient for many coatings. Convenient materials for constructing plate 21 are graphite and aluminum depending on the maximum temperature required. Graphite can sustain very high temperatures in a vacuum, while aluminum is limited to a few hundred degrees Centigrade. For example support structure 20 can be configured to hold an array of quartz lamps in a reflecting housing to attain even higher substrate temperatures solely by radiative heat transfer. In order to maintain the substrate temperature between coating stations, conformal heaters 25 using similar tubular heating elements 23 can be used to heat the substrate in the regions where it is in contact with rollers 9. Heating/cooling unit 12 may be removed in its entirety and replaced by a magnetron to provide a coating on the back side of the substrate.

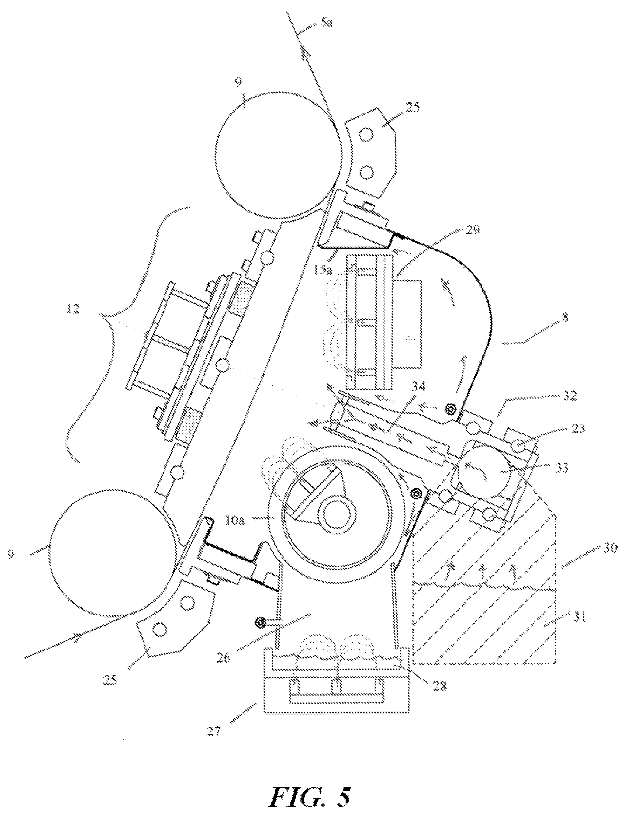

As mentioned above, **FIG. 4** illustrates a basic metal or metal alloy sputtering setup for a chamber using dual rotatable magnetrons. **FIG. 5** shows other useful configurations for sputtering one or more material layers of a photovoltaic cell, or for other coating applications. While **FIG. 5** can be used to form layers of thin film photovoltaic cell, various configurations, modifications and alternatives to the deposition chamber of **FIG. 5** may be employed. For example, reactive sputtering of a metal or alloy by including oxygen or nitrogen gas with the argon working gas, or by separate injection, is a common sputtering technique, but that configuration is not explicitly considered in the present discussion.

With reference to **FIG. 5****,** chamber 8 can be modified to include a smaller chamber 26 that holds a specialized vertical planar magnetron 27 designed to sputter a conductive liquid metal 28 like gallium, mercury, or cesium. In the CIGS solar cell application, the liquid metal 28 can be gallium, which may be kept sufficiently warm by the sputtering conditions to be in a molten (or liquid) state. For the CIGS application the target material 10a on the rotatable magnetron can be indium. This is a particularly advantageous transfer sputtering arrangement since indium and gallium form a low temperature eutectic that makes it impractical to use as a pre-alloyed target. This sputtering configuration can be implemented on the lower of the two magnetrons at any of the six sputtering stations shown in **FIG. 3****,** and can be on both magnetrons on the two lower stations. Certain details and example advantages of the use of this transfer sputtering configuration are described in PCT/US2012/050418, which is entirely incorporated herein by reference.

Still with reference to **FIG. 5****,** either or both of the rotatable magnetrons may be replaced with a conventional planar magnetron 29 if a particular coating requires it. This situation can arise when a desired material cannot be made in a tubular form for use with a rotatable magnetron, or if it can be made, it is at a prohibitive cost. As an example, in the deposition of CIGS solar cells, the thin buffer layer is usually comprised of cadmium sulfide (CdS), which may not be available in rotatable magnetron form, but can be sputtered using a planar magnetron.

A third chamber configuration shown in **FIG. 5** is an apparatus for adding a vapor to the sputtering flux to create a reacted coating. It comprises the dashed and cross-hatched element 30 which represents a container for heating a material like selenium or sulfur 31, and a vapor distribution system 32. This container is not a part of the cross section of the rest of the drawing, but rather it is located at one end of the chamber. The vapor flows through a metering valve (not shown) and into the vapor distribution system which consists of a linear chamber 33 that directs the vapor through a series of apertures into an expansion chamber 34 between the magnetrons, and then into the sputtering plasma zone. Vapor distribution system 32 is constructed of heat conducting material, and the system is kept hot enough to prevent vapor condensation by tubular heating elements 23 that are similar to those described in other heating locations.

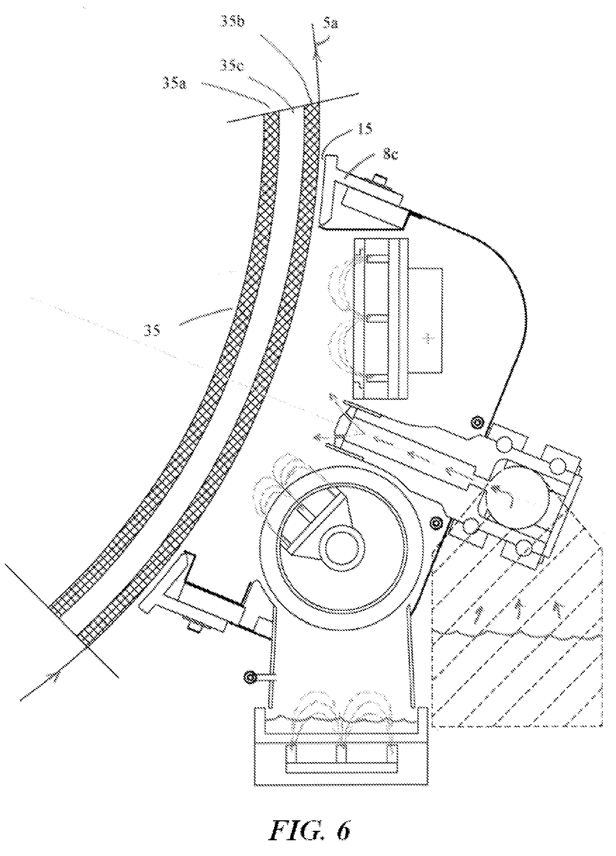

**FIG. 6** shows the chamber configurations of **FIG. 5** when used in conjunction with a conventional coating drum. The rollers (9), the heating/cooling unit (12), and the conformal heaters (25) shown in **FIG. 5** are removed and replaced with the segment of a drum 35. The drum may consist of an inner wall 35a and an outer wall 35b with a space 35c in between that can be used for a heating or a cooling fluid. Alternatively the drum can be solid (if cooling is not required) and heated by internal lamps (not shown). Substrate 5a is now carried on the surface of drum outer wall 35b rather than being free span between rollers. In such a case, conduction limiter 8c is changed in shape to conform to the drum curvature and create a variable uniform conduction gap 15. All of the other elements of **FIG. 6** are identical to those of **FIG. 5** and are not specifically labeled. As discussed elsewhere herein, the drum may be used for coating a substrate formed of a polymeric material since it may have a low tolerance to heating. Optical films coated on a transparent polyethylene terephthalate (PET) type of substrate can be an example of an appropriate use for the coating drum. Such films can have application as antireflection layers to enhance solar cell performance, or they can serve as moisture barrier films to replace the glass in solar modules.

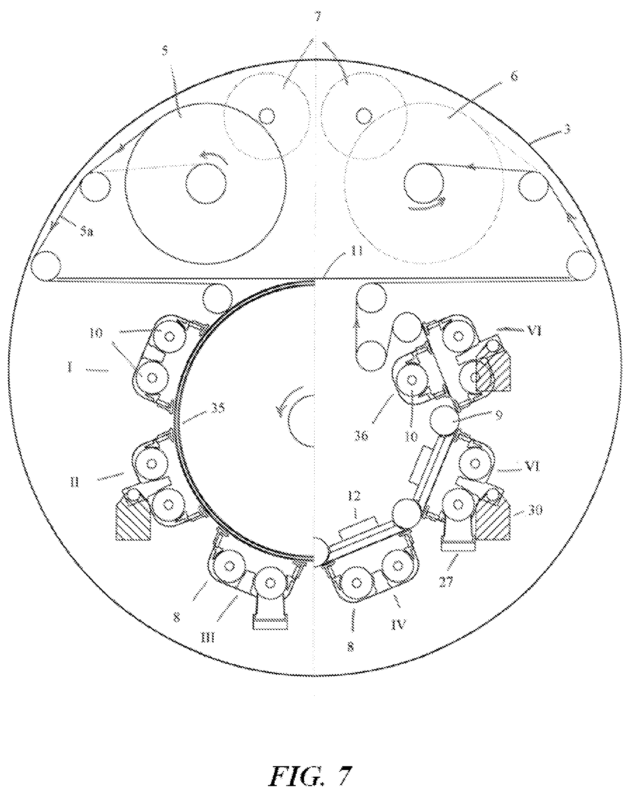

Several examples of chamber configurations for both the drum (stations I, II, and III) and free span (stations IV, V, and VI) versions of the machine architecture are illustrated in FIG. 7. The configuration examples are randomly placed, not implying any relationship to a process. To reduce drawing complexity, the chamber configurations are represented by simplified versions (e.g., as in **FIG. 3**) of the more detailed descriptions of those shown in **FIGs. 4****,****5****, and** **6****;** however, the major elements are easily identified by the several numerical labels that refer back to the more detailed figures. The right side of the figure illustrates the free span machine configuration that can be employed for high modulus and high temperature resistant substrates, such as thin flexible metal foils. It also shows that a smaller chamber 35 fitted with a single rotatable magnetron 10 may replace the heater/cooler unit to allow coating on the back side of the substrate. This configuration can be replaced with or modified by any of the coating stations described herein. The left side illustrates a conventional coating drum configuration that can be useful for coating low strength and/or low temperature resistant polymeric substrates. Any of the rotatable magnetrons can be replaced with conventional planar magnetrons where particular materials may be needed that are not available in rotatable format.

### Controllers

Systems and methods of the disclosure can be implemented with the aid of computer systems. A system can include an enclosure comprising one or more deposition systems, and a pumping system. A computer system (or controller) can be coupled to the system. The computer system can include a computer processor (also "processor" herein) for executing machine readable code implementing a method for forming a photovoltaic cell. The code may implement any of the methods provided herein.

A controller can be coupled to various components of the system. For instance, the controller can be in communication with the one or more deposition systems, including magnetron sputtering apparatuses of the one or more deposition systems. As another example, the controller can be in communication with the pumping system, which can enable the controller to regulate a pressure of the enclosure.

A controller can be programmed or otherwise configured to regulate one or more processing parameters, such as the substrate temperature, precursor flow rates, growth rate, carrier gas flow rate, deposition chamber pressure and magnetron power. The controller, in some cases, is in communication with a valve or a plurality of valves of a deposition chamber, which aids in terminating (or regulating) the flow of a precursor in the deposition chamber. The controller includes a processor configured to aid in executing machine-executable code that is configured to implement the methods provided herein. The machine-executable code is stored on a physical storage medium, such as flash memory, a hard disk, or other physical storage medium configured to store computer-executable code.

A controller can be programmed or otherwise configured to regulate one or more processing parameters. In some situations, the controller regulates one or more of the growth temperature, carrier gas flow rate, precursor flow rate, photovoltaic material layer growth rate and growth pressure. Growth rate can be regulated, for example, by controlling the rate at which a portion of a substrate is directed through a deposition chamber, which can be dependent on the rate at which the substrate payout and update rolls (e.g., rolls 5 and 6 of **FIG. 2**) rotate.

For instance, the system of **FIG. 1** can include a controller (or control system) that is programmed or otherwise configured to regulate one or more processing parameters of the system, such as substrate temperature, precursor flow rates, magnetron sputtering operation (e.g., magnetron power), RF power, heater power, growth rate, carrier gas flow rate, the pressure within the enclosure, the pressure within individual deposition chambers, the rate at which the payout roller rotates, and the rate at which the take-up roller rotates. The controller can be in communication with various components of the system, including, without limitation, the modules, valves between the modules, precursor valves, the pumping system of the system (not shown). The controller includes a processor configured to aid in executing machine-executable code that is configured to implement the methods provided above and elsewhere herein. The machine-executable code is stored on a physical storage medium (not shown), such as flash memory, a hard disk, or other physical storage medium configured to store computer-executable code.

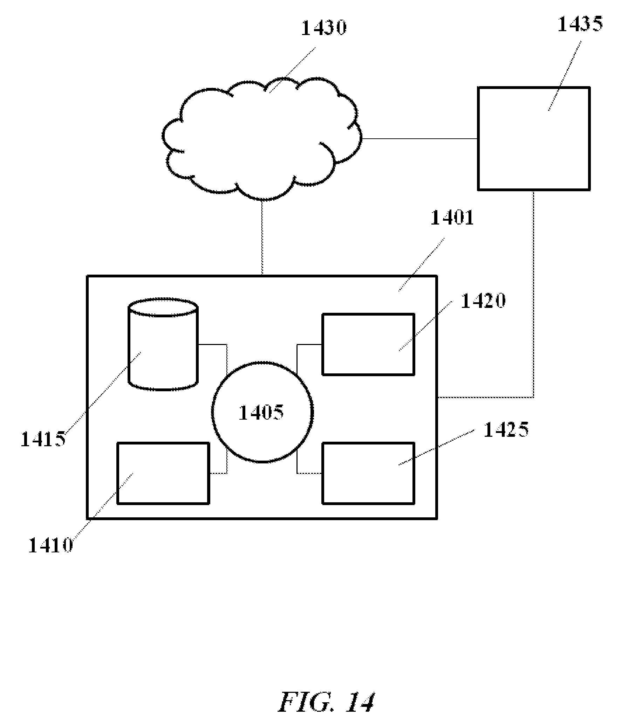

**FIG. 14** schematically illustrates a computer system (also "controller" herein) 1401 programmed or otherwise configured to facilitate the formation of photovoltaic (PV) cells of the disclosure. The computer system **1401** can be programmed or otherwise configured to implement methods described herein. The computer system **1401** includes a central processing unit (CPU, also "processor" and "computer processor" herein) **1405,** which can be a single core or multi core processor, or a plurality of processors for parallel processing. The computer system **1401** also includes memory **1410** (e.g., random-access memory, read-only memory, flash memory), electronic storage unit **1415** (e.g., hard disk), communications interface **1420** (e.g., network adapter) for communicating with one or more other computer systems, and peripheral devices **1425,** such as cache, other memory, data storage and/or electronic display adapters. The memory **1410,** storage unit **1415,** interface **1420** and peripheral devices **1425** are in communication with the CPU **1405** through a communications bus (solid lines), such as a motherboard. The storage unit **1415** can be a data storage unit (or data repository) for storing data. The computer system **1401** is operatively coupled to a computer network ("network") **1430** with the aid of the communications interface **1420.** The network **1430** can be the Internet, an internet and/or extranet, or an intranet and/or extranet that is in communication with the Internet. The network **1430** in some cases is a telecommunication and/or data network. The network **1430** can include one or more computer servers, which can enable distributed computing, such as cloud computing. The network **1430** in some cases, with the aid of the computer system **1401,** can implement a peer-to-peer network, which may enable devices coupled to the computer system **1401** to behave as a client or a server.

The computer system **1401** is in communication with a processing system **1435** for forming one or more components (e.g., absorber, back electrode, front electrode) of photovoltaic cells of the disclosure. The processing system **1435** can be configured to implement various operations to form one or more PV cell component structures adjacent to a substrate in the processing system **1435,** such as, for example, forming one or more absorber layers. The processing system **1435** can be in communication with the computer system **1401** through the network **1430,** or by direct (e.g., wired, wireless) connection. In an example, the processing system **1435** is the system described above in the context of **FIG. 1****.**

Methods as described herein can be implemented by way of machine (or computer processor) executable code (or software) stored on an electronic storage location of the computer system **1401,** such as, for example, on the memory **1410** or electronic storage unit **1415.** During use, the code can be executed by the processor **1405.** In some examples, the code can be retrieved from the storage unit **1415** and stored on the memory **1410** for ready access by the processor **1405.** In some situations, the electronic storage unit **1415** can be precluded, and machine-executable instructions are stored on memory **1410.**

The code can be pre-compiled and configured for use with a machine have a processer adapted to execute the code, or can be compiled during runtime. The code can be supplied in a programming language that can be selected to enable the code to execute in a pre-compiled or as-compiled fashion.

Aspects of the systems and methods provided herein can be embodied in programming. Various aspects of the technology may be thought of as "products" or "articles of manufacture" typically in the form of machine (or processor) executable code and/or associated data that is carried on or embodied in a type of machine readable medium. Machine-executable code can be stored on an electronic storage unit, such memory (e.g., read-only memory, random-access memory, flash memory) or a hard disk. "Storage" type media can include any or all of the tangible memory of the computers, processors or the like, or associated modules thereof, such as various semiconductor memories, tape drives, disk drives and the like, which may provide non-transitory storage at any time for the software programming. All or portions of the software may at times be communicated through the Internet or various other telecommunication networks. Such communications, for example, may enable loading of the software from one computer or processor into another, for example, from a management server or host computer into the computer platform of an application server. Thus, another type of media that may bear the software elements includes optical, electrical and electromagnetic waves, such as used across physical interfaces between local devices, through wired and optical landline networks and over various air-links. The physical elements that carry such waves, such as wired or wireless links, optical links or the like, also may be considered as media bearing the software. As used herein, unless restricted to non-transitory, tangible "storage" media, terms such as computer or machine "readable medium" refer to any medium that participates in providing instructions to a processor for execution.

Hence, a machine readable medium, such as computer-executable code, may take many forms, including but not limited to, a tangible storage medium, a carrier wave medium or physical transmission medium. Non-volatile storage media include, for example, optical or magnetic disks, such as any of the storage devices in any computer(s) or the like, such as may be used to implement the databases, etc. shown in the drawings. Volatile storage media include dynamic memory, such as main memory of such a computer platform. Tangible transmission media include coaxial cables; copper wire and fiber optics, including the wires that comprise a bus within a computer system. Carrier-wave transmission media may take the form of electric or electromagnetic signals, or acoustic or light waves such as those generated during radio frequency (RF) and infrared (IR) data communications. Common forms of computer-readable media therefore include for example: a floppy disk, a flexible disk, hard disk, magnetic tape, any other magnetic medium, a CD-ROM, DVD or DVD-ROM, any other optical medium, punch cards paper tape, any other physical storage medium with patterns of holes, a RAM, a ROM, a PROM and EPROM, a FLASH-EPROM, any other memory chip or cartridge, a carrier wave transporting data or instructions, cables or links transporting such a carrier wave, or any other medium from which a computer may read programming code and/or data. Many of these forms of computer readable media may be involved in carrying one or more sequences of one or more instructions to a processor for execution.

### EXAMPLES

### EXAMPLE 1 - Back Electrode Layer for CIGS

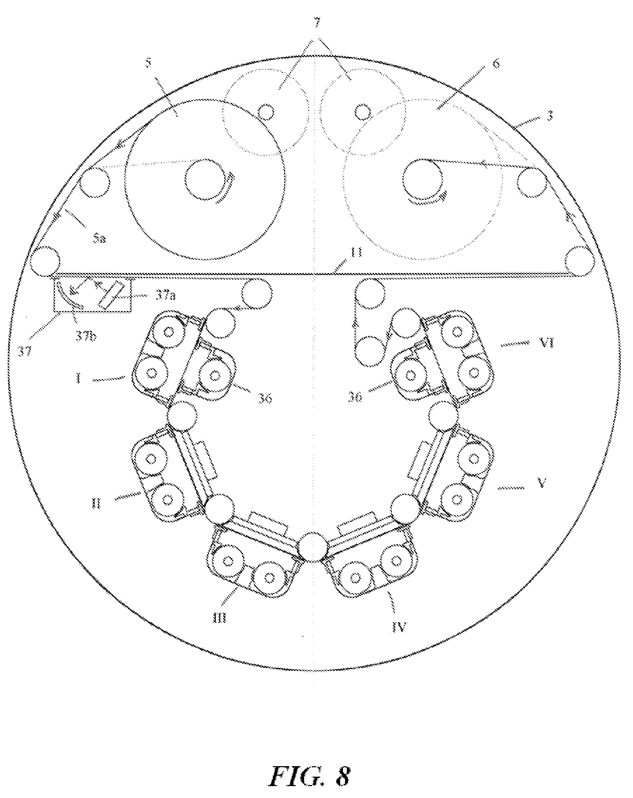

A machine configuration for coating the back electrode layer for a CIGS solar cell on a web of thin stainless steel (SS) foil is shown in **FIG. 8****.** This example employs a molybdenum back electrode, though other materials, such as tungsten and niobium, may be used.

Some substrates might be improved by an in vacuum surface treatment. One such treatment can be a sputter etching of the foil surface to remove foreign material, reduce topology, or remove a thin layer of oxide buildup. **FIG. 8** indicates a small auxiliary chamber 37 located on a free span upstream portion of the web. This chamber houses an ion gun 37a which is oriented at an angle to the substrate to provide more efficient etching, and to direct the etched debris towards a catching shield 37b thus reducing deposition on the ion gun itself. The ion gun is fed with argon (or other inert gas, such as, e.g., He) as a working gas, the pressure of which is higher in the chamber 37 than outside of the chamber 37.

Referring still to **FIG. 8** the web exits chamber 37 and continues on to coating station I. A first set of dual magnetrons can be used to deposit a thin layer of chromium, titanium, or other reactive metal on or adjacent to the substrate to serve as an adhesion promoting layer as well as a layer to help block any diffusion of iron from the substrate. Stations II through VI can be used to deposit the molybdenum layer; however, an intermediate layer of a different metal (for instance at station IV) may be used to create composition boundaries or interfaces that also help block the migration of iron. Smaller chambers 36 with single magnetrons may be placed at any of the stations to provide a back side coating to perform a variety of functions, such as enabling electrical connectivity among adjacent photovoltaic cells in a photovoltaic module.

### EXAMPLE 2 - Absorber Layer for CIGS

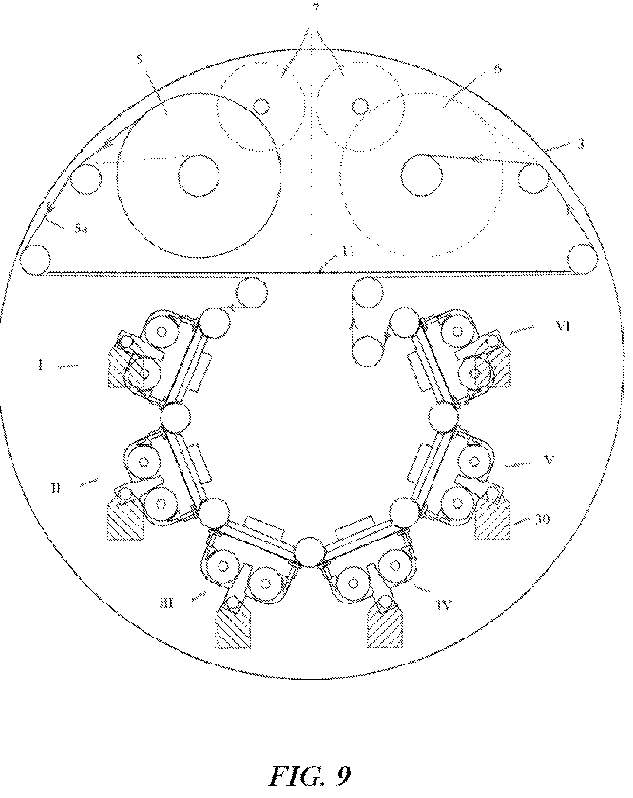

**FIG. 9** illustrates a system for depositing a CIGS precursor layer. Each coating station is shown equipped with a vapor source 30 which can provide vaporized selenium during the deposition of the layer. The target materials comprise copper, indium, and gallium, but several arrangements are possible. For example the two magnetrons at each coating station may have one magnetron with an indium target and one with a copper/gallium alloy target - i.e. each station being identical. Alternatively, the compositions of the targets may be varied from station to station. In other arrangements both targets at any station may be identical. Additionally, any of the copper/gallium alloy targets can be replaced with pure copper targets, with the gallium being sputtered from its liquid phase as shown by source 27 of **FIG. 5** onto either copper or indium targets.

CIGS solar cells may benefit from the addition of a small amount of sodium, of the order of 0.1%. In some cases, a small amount of sodium can be provided in the form of atomic sodium or a compound comprising sodium (e.g., NaF, NaSe, NaS, etc.) in one or more of the CIGS targets, for ultimate deposition in a growing CIGS absorber adjacent to a substrate. However, it can also be included in the molybdenum back electrode where it can diffuse into the CIGS. Another alternative is to deposit a sodium compound layer by sputtering from a planar magnetron(s) housed in a chamber 37 shown in **FIG. 8****.** Chamber 37 can also be used to house equipment to deposit a layer of the sodium compound by evaporation. The sodium compound may be deposited on the molybdenum back electrode layer, or on top of the CIGS layer by placing chamber 37 in the symmetrical location from that shown in **FIG. 8****.**

### EXAMPLE 3 - Sputtered Junction Layer for CIGS

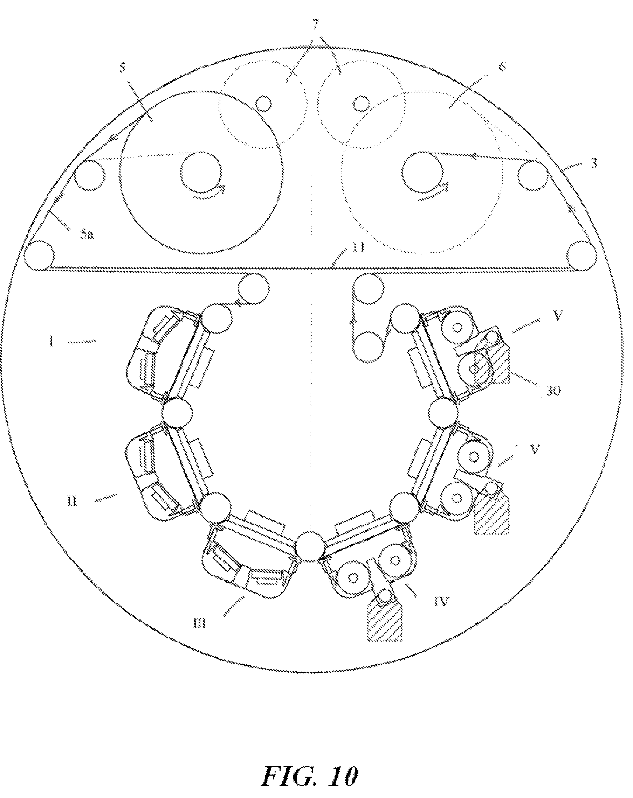

The highest efficiency CIGS solar cells produced in the laboratory have used chemical bath deposition of cadmium sulfide (CdS) as a junction layer; however, commercial CIGS modules have also used cells with chemically deposited junction layers of zinc sulfide (ZnS) and indium sulfide (In₂S₃). It is possible to produce the junction layer by sputtering, and **FIG. 10** shows a system configuration for this application. The left side of the machine (stations I-III) illustrates the planar magnetron sputtering of CdS planar targets. Pure CdS is highly resistive and can be sputtered with radio frequency (RF) energy, but a metal doped or off stoichiometry version can be sputtered with alternating current (AC) power. Stations IV-VI are shown configured in a manner that can permit the sputtering of a reactive ZnS or In₂S₃ junction layer. The rotatable targets are either zinc metal or indium metal and they are sputtered in the presence of sulfur vapor provided by sources 30. In some processes a thin layer of intrinsic or highly resistive zinc oxide (iZnO) is deposited on top of the junction layer. Highly resistive planar zinc oxide targets can be radiofrequency (RF) sputtered (like the CdS) for this purpose, or slightly doped zinc oxide can be sputtered with AC in the presence of a small amount of oxygen to restore the highly resistive stoichiometry.

### EXAMPLE 4 - Sputtered Transparent Top Electrode for CIGS

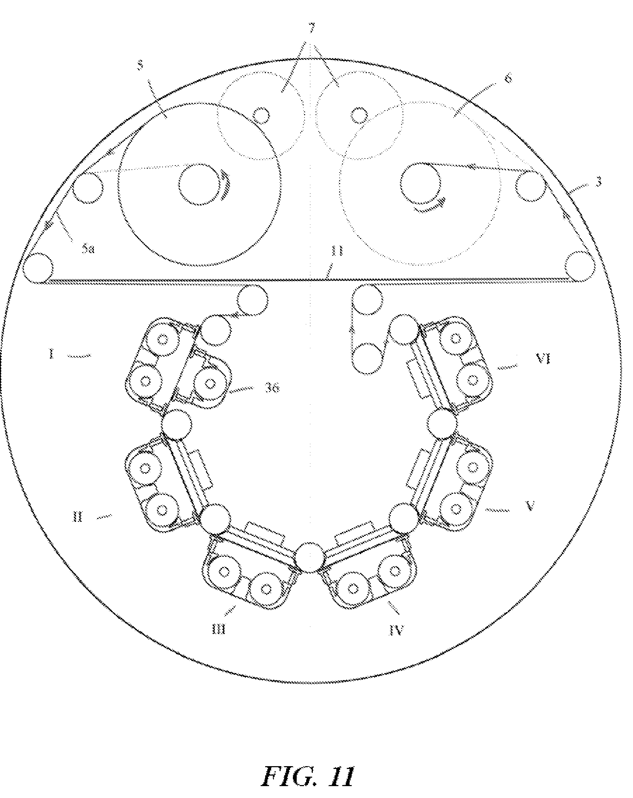

Unlike conventional silicon solar cells, thin film cells need a transparent top electrode which is almost always deposited by sputtering. Indium tin oxide (ITO) and zinc oxide slightly doped with aluminum (AZO) are two materials that can be used for this purpose. Both can be provided in rotatable format, and both are sufficiently conductive to sputter by direct current (DC), pulsed DC, or AC power. **FIG. 11** shows a system for sputter deposition of a transparent top electrode. It is very similar to the configuration for sputtering the back electrode, except that there is no ion etch and the targets are conductive oxides, ITO and/or AZO, instead of metals. AC or pulsed DC mode in some cases can advantageously provide for long term process stability because of control of arcing. It is also possible to make an iZnO-like layer using the AZO targets by adding a small amount of oxygen to the plasma while sputtering. This can be used in place of sputtering iZnO by RF, as described in the example above. Also, a back side coating can be formed using a single magnetron chamber 35 at selected positions, as described above or elsewhere herein.

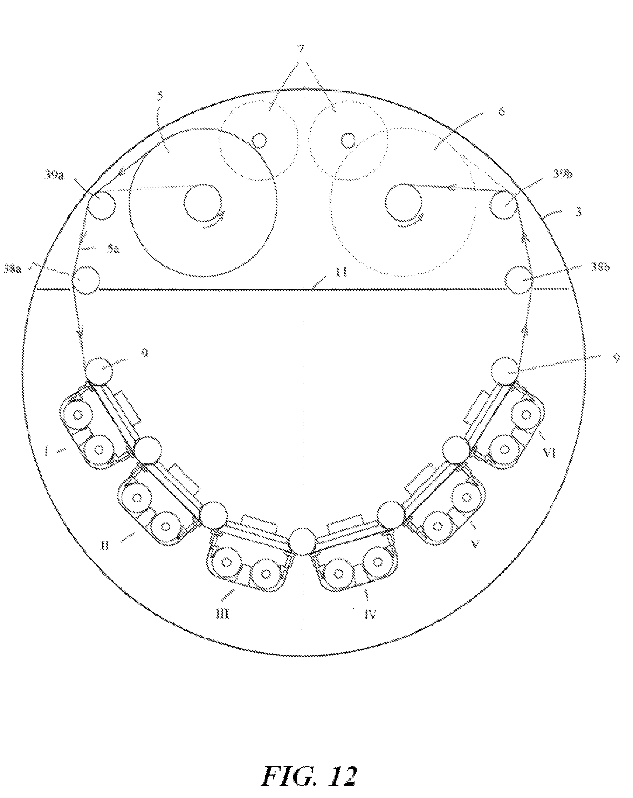

Suppliers may not be able to provide stainless steel foil substrates as smooth and as devoid of surface defects as glass. As a result, thin film solar cells made on flexible stainless steel webs can have large numbers of electrical defects that can be employed in a manufacturing environment. Transport rollers in a web coating machine that touch the coating side of the web can induce a number of defects due to sliding and scratching, or by simply mashing particles into the coating. **FIG. 12** illustrates a machine configuration that allows the coatings to be accomplished without transport roller contact with the coated side of the web. The coating stations are rearranged to form a more open arc. Basically stations III and IV are unchanged while pairs I and II and V and VI are moved downward. Rollers 38a and 38b are moved slightly toward the center of the machine to allow a small wrap angle on rollers 9. The wrap angle on the rollers 9 can be at less than or equal to about 20°, 15°, 10°, 9°, 8°, 7°, 6°, 5°, 4°, 3°, 2°, or 1°. The wrap angle on rollers 39a and 39b are increased somewhat by this movement so that they may be equipped with both load cell and web speed sensors. The wrap angle on rollers 39a and 39b can be at least about 10°, 20°, 30°, 40°, or 45°. The web tension and speed information is fed to the drives on substrate rolls 5 and 6 for feed-back web transport control. The chance of web slippage on rollers 39a and 39b is greatly reduced, even with small wrap angle, by the use of a magnetically enhanced roller, such as, for example, a magnetically enhanced roller described in PCT/US2012/052159, which is entirely incorporated herein by reference.

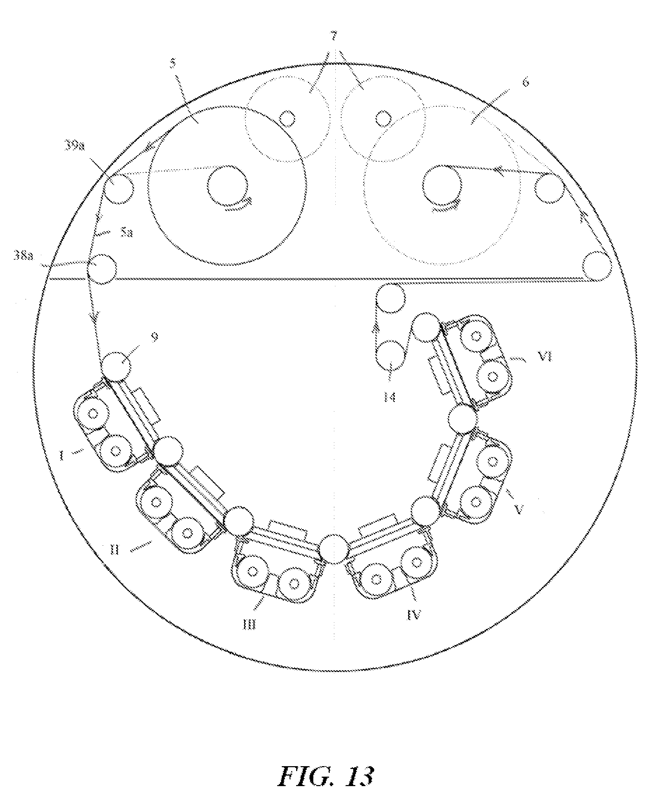

In some cases, it may be permissible to have a roller contact with the coated side of the web after a coating is applied - for example, after the final top transparent electrode is deposited. **FIG. 13** schematically illustrates a hybrid system in which a roller contacts with a coated side of a web after a coating is applied adjacent to a substrate. On the left side the arrangement is identical to that described in **FIG. 12****,** but on the right side the configuration is like the previous standard configuration with the "S" wrap drive using roller 14. The coated side of the substrate comes in contact with the roller 14. The configuration of **FIG. 13** may be used in cases in which a non-magnetic foil or polymer substrate with an unusually low coefficient of friction is used with sensing roller 39a.

Devices, systems and methods of the disclosure may be combined with or modified by other devices, systems and methods, such as devices, systems and/or methods described in U.S. Patent No. 8,207,012 to Pinarbasi et al., U.S. Patent No. 4,318,938 to Barnett et al., U.S. Patent No. 6,974,976 to Hollars, U.S. Pat. No. 5,571,749 to Matsuda et al., U.S. Patent Nos. 6,310,281 and 6,372,538 to Wendt et al., U.S. Patent No. 4,298,444 to Chahroudi, U.S. Patent Publication No. 2010/0140078 to Pinarbasi et al., and U.S. Patent Publication No. 2012/0006398 to Nguyen et al., each of which is entirely incorporated herein by reference.

Unless the context clearly requires otherwise, throughout the description and the claims, words using the singular or plural number also include the plural or singular number respectively. Additionally, the words 'herein,' 'hereunder,' 'above,' 'below,' and words of similar import refer to this application as a whole and not to any particular portions of this application. When the word 'or' is used in reference to a list of two or more items, that word covers all of the following interpretations of the word: any of the items in the list, all of the items in the list and any combination of the items in the list.

It should be understood from the foregoing that, while particular implementations have been illustrated and described, various modifications may be made thereto and are contemplated herein. An embodiment of one aspect of the disclosure may be combined with or modified by an embodiment of another aspect of the disclosure. It is not intended that the invention(s) be limited by the specific examples provided within the specification. While the invention(s) has (or have) been described with reference to the aforementioned specification, the descriptions and illustrations of embodiments of the invention(s) herein are not meant to be construed in a limiting sense. Furthermore, it shall be understood that all aspects of the invention(s) are not limited to the specific depictions, configurations or relative proportions set forth herein which depend upon a variety of conditions and variables. Various modifications in form and detail of the embodiments of the invention(s) will be apparent to a person skilled in the art. It is therefore contemplated that the invention(s) shall also cover any such modifications, variations and equivalents.

## Claims

1. A deposition system for depositing a thin film photovoltaic cell on a flexible substrate, comprising:
a) an enclosure comprising a fluid space that is fluidically isolated from an environment external to said enclosure;
b) a plurality of deposition chambers in said fluid space, wherein at least one deposition chamber of said plurality of deposition chambers comprises a magnetron sputtering apparatus that directs a material flux of one or more target materials towards a portion of said flexible substrate that is disposed in said at least one deposition chamber of said plurality of deposition chambers;
b1) wherein each of said deposition chambers that comprises a magnetron sputtering apparatus includes openings through which said flexible substrate passes and adjustable conductance limiters arranged at said openings to form a gap between said substrate and said conductance limiter;
c) a substrate payout roller and a substrate take-up roller in said enclosure, wherein said substrate payout roller provides a flexible substrate that is directed through each of said plurality of deposition chambers to said substrate take-up roller; and
d) at least one guide roller in said enclosure, wherein said guide roller is configured to direct said flexible substrate to or from a given deposition chamber among said plurality of deposition chambers;
wherein said at least one deposition chamber comprises a magnetron sputtering apparatus comprising:
a rotatable magnetron adjacent to a planar magnetron; and
one or more shields forming a sub-chamber between said rotatable magnetron and said planar magnetron,
wherein said planar magnetron is configured to contain a liquid target having a first material and provide a material flux having said first material towards said rotatable magnetron, and
wherein said rotatable magnetron is configured to rotate a solid target having a second material in relation to said planar magnetron and provide a material flux having said first and second materials towards said flexible substrate.

2. The deposition system of Claim 1, wherein said first material has a first melting point that is lower than a second melting point of said second material.

3. The deposition system of Claim 1, wherein said first material is gallium and said second material is indium.

4. The deposition system of Claim 1, wherein said rotatable magnetron is at least partially cylindrical in shape.

5. The deposition system of Claim 1, wherein said planar magnetron comprises a backing plate adjacent to a magnetron body, and wherein said magnetron body includes one or more magnets and said backing plate is adapted to hold said liquid target.

6. The deposition system of Claim 1, wherein said rotatable magnetron comprises a support member adapted to rotate said solid target in relation to said planar magnetron.

7. The deposition system of Claim 1, wherein said planar magnetron is adapted to contain another liquid having a third material.

8. The deposition system of Claim 1, wherein said planar magnetron is configured to provide a flux of said first material in said chamber.

9. The deposition system of Claim 1, further comprising another planar magnetron adjacent to said planar magnetron, wherein said another planar magnetron is configured to provide a flux of a third material in said chamber.

10. The deposition system of Claim 1, further comprising another magnetron apparatus adjacent to said magnetron apparatus, wherein said another magnetron apparatus is configured to provide a flux of a third material towards said substrate.

11. The deposition system of Claim 10, wherein said magnetron assemblies are enclosed in another chamber having an opening adapted to expose said substrate.

12. The deposition system of Claim 10, wherein said first material is gallium, said second material is one of indium and copper, and said third material the other of indium and copper.

13. The deposition system of Claim 1, further comprising a source of a third material adjacent to said magnetron apparatus.

14. The deposition system of Claim 13, wherein said third material is sulfur or selenium.

15. A deposition system for depositing a thin film photovoltaic cell on a flexible substrate, comprising:
a) an enclosure comprising a fluid space that is fluidically isolated from an environment external to said enclosure;
b) a plurality of deposition chambers in said fluid space, wherein said plurality of deposition chambers comprise a first deposition chamber and a second deposition chamber, wherein said first deposition chamber comprises a magnetron sputtering apparatus that directs a first material flux towards a first side of a portion of said flexible substrate, and wherein said second deposition chamber comprises a magnetron sputtering apparatus that directs a second material flux towards a second side of said portion that is opposite from said first side;
b1) wherein each of said first and second deposition chambers includes openings through which said flexible substrate passes and adjustable conductance limiters arranged at said openings to form a gap between said substrate and said conductance limiter; and
c) a payout roller and a take-up roller in said enclosure, wherein said payout roller sequentially directs said flexible substrate to said take-up roller through each of said plurality of deposition chambers;
wherein at least one of said plurality of deposition chambers comprises a magnetron sputtering apparatus comprising:
a rotatable magnetron sputtering apparatus adjacent to a planar magnetron sputtering apparatus; and
one or more shields forming a sub-chamber between said rotatable magnetron sputtering apparatus and said planar magnetron sputtering apparatus,
wherein said planar magnetron sputtering apparatus is configured to contain a liquid target having a first material and provide a material flux having said first material towards said rotatable magnetron, and
wherein said rotatable magnetron sputtering apparatus is configured to rotate a solid target having a second material in relation to said planar magnetron sputtering apparatus and provide a material flux having said first and second materials towards said flexible substrate.

## Patentansprüche

1. Ein Abscheidungssystem zum Abscheiden einer Dünnschicht-Photovoltaikzelle auf einem flexiblen Substrat, beinhaltend:
a) ein Gehäuse, beinhaltend einen Flüssigkeitsraum, der von einer zum Gehäuse externen Umgebung strömungstechnisch isoliert ist;
b) eine Vielzahl von Abscheidungskammern in dem Flüssigkeitsraum, wobei wenigstens eine Abscheidungskammer der Vielzahl von Abscheidungskammern eine Magnetron-Zerstäubungsvorrichtung beinhaltet, die einen Materialfluss von einem oder mehreren Zielmaterialien hin zu einem Abschnitt des flexiblen Substrats, das in der wenigstens einen Abscheidungskammer der Vielzahl von Abscheidungskammern angebracht ist, lenkt;
b1) wobei jede der Abscheidungskammern, die eine Magnetron-Zerstäubungsvorrichtung beinhaltet, Öffnungen, durch welche das flexible Substrat passiert, und anpassbare Leitfähigkeitsbegrenzer, die an den Öffnungen angeordnet sind, um einen Spalt zwischen dem Substrat und dem Leitfähigkeitsbegrenzer zu bilden, umfasst;
c) eine Substrat-Ausgabewalze und eine Substrat-Aufnahmewalze in dem Gehäuse, wobei die Substrat-Ausgabewalze ein flexibles Substrat bereitstellt, das durch jede der Vielzahl von Abscheidungskammern zu der Substrat-Aufnahmewalze geleitet wird; und
d) wenigstens eine Führungswalze in dem Gehäuse, wobei die Führungswalze konfiguriert ist, um das flexible Substrat zu oder von einer bestimmten Abscheidungskammer unter der Vielzahl von Abscheidungskammern zu leiten;
wobei die wenigstens eine Abscheidungskammer eine Magnetron-Zerstäubungsvorrichtung beinhaltet, beinhaltend:
ein drehbares, einem planaren Magnetron benachbartes, Magnetron; und ein oder mehrere Schilde, die eine Unterkammer zwischen dem drehbaren Magnetron und dem planaren Magnetron bilden,
wobei das planare Magnetron konfiguriert ist, um ein flüssiges Ziel mit einem ersten Material zu enthalten und um einen Materialfluss mit dem ersten Material hin zu dem drehbaren Magnetron bereitzustellen, und
wobei das drehbare Magnetron konfiguriert ist, um ein festes Ziel mit einem zweiten Material bezüglich des planaren Magnetrons zu drehen und einen Materialfluss mit den ersten und zweiten Materialien hin zum flexiblen Substrat bereitzustellen.

2. Abscheidungssystem gemäß Anspruch 1, wobei das erste Material einen ersten Schmelzpunkt aufweist, der niedriger ist als ein zweiter Schmelzpunkt des zweiten Materials.

3. Abscheidungssystem gemäß Anspruch 1, wobei das erste Material Gallium ist und das zweite Material Indium ist.

4. Abscheidungssystem gemäß Anspruch 1, wobei das drehbare Magnetron wenigstens teilweise zylindrischer Gestalt ist.

5. Abscheidungssystem gemäß Anspruch 1, wobei das planare Magnetron eine dem Magnetronkörper benachbarte Trägerplatte beinhaltet, und wobei der Magnetronkörper einen oder mehrere Magnete umfasst und die Trägerplatte dazu ausgelegt ist, das flüssige Ziel zu fassen.

6. Abscheidungssystem gemäß Anspruch 1, wobei das drehbare Magnetron ein Stützelement beinhaltet, dazu ausgelegt, das feste Ziel in Bezug auf das planare Magnetron zu drehen.

7. Abscheidungssystem gemäß Anspruch 1, wobei das planare Magnetron dazu ausgelegt ist, eine weitere Flüssigkeit mit einem dritten Material zu enthalten.

8. Abscheidungssystem gemäß Anspruch 1, wobei das planare Magnetron konfiguriert ist, einen Fluss des ersten Materials in der Kammer bereitzustellen.

9. Abscheidungssystem gemäß Anspruch 1, ferner beinhaltend ein dem planaren Magnetron benachbartes weiteres planares Magnetron, wobei das weitere planare Magnetron konfiguriert ist, um einen Fluss eines dritten Materials in der Kammer bereitzustellen.

10. Abscheidungssystem gemäß Anspruch 1, ferner beinhaltend eine der Magnetronvorrichtung benachbarte weitere Magnetronvorrichtung, wobei die weitere Magnetronvorrichtung konfiguriert ist, um einen Fluss eines dritten Materials hin zu dem Substrat bereitzustellen.

11. Abscheidungssystem gemäß Anspruch 10, wobei die Magnetronzusammenbauten in einer weiteren Kammer mit einer Öffnung, dazu ausgelegt, das Substrat zu exponieren, umschlossen sind.

12. Abscheidungssystem gemäß Anspruch 10, wobei das erste Material Gallium ist, das zweite Material eines von Indium und Kupfer ist, und das dritte Material das andere von Indium und Kupfer ist.

13. Abscheidungssystem gemäß Anspruch 1, ferner beinhaltend eine der Magnetronvorrichtung benachbarte Quelle eines dritten Materials.

14. Abscheidungssystem gemäß Anspruch 13, wobei das dritte Material Schwefel oder Selen ist.

15. Ein Abscheidungssystem zum Abscheiden einer Dünnschicht-Photovoltaikzelle auf einem flexiblen Substrat, beinhaltend:
a) ein Gehäuse, beinhaltend einen Flüssigkeitsraum, der von einer zum Gehäuse externen Umgebung strömungstechnisch isoliert ist;
b) eine Vielzahl von Abscheidungskammern in dem Flüssigkeitsraum, wobei die Vielzahl von Abscheidungskammern eine erste Abscheidungskammer und eine zweite Abscheidungskammer beinhalten, wobei die erste Abscheidungskammer eine Magnetron-Zerstäubungsvorrichtung beinhaltet, die einen ersten Materialfluss hin zu einer ersten Seite eines Abschnitts des flexiblen Substrats lenkt, und wobei die zweite Abscheidungskammer eine Magnetron-Zerstäubungsvorrichtung beinhaltet, die einen zweiten Materialfluss hin zu einer zweiten Seite des Abschnitts, die der ersten Seite gegenüberliegt, lenkt;
b1) wobei jede der ersten und zweiten Abscheidungskammern Öffnungen, durch welche das flexible Substrat passiert, und einstellbare Leitfähigkeitsbegrenzer, die an den Öffnungen angeordnet sind, um einen Spalt zwischen dem Substrat und dem Leitfähigkeitsbegrenzer zu bilden, umfassen; und
c) eine Ausgabewalze und eine Aufnahmewalze in dem Gehäuse, wobei die Ausgabewalze das flexible Substrat aufeinanderfolgend durch jede der Vielzahl von Abscheidungskammern zur Aufnahmewalze lenkt;
wobei wenigstens eine der Vielzahl von Abscheidungskammern eine Magnetron-Zerstäubungsvorrichtung beinhaltet, beinhaltend:
eine einer planaren Magnetron-Zerstäubungsvorrichtung benachbarte drehbare Magnetron-Zerstäubungsvorrichtung; und
ein oder mehrere Schilde, die eine Unterkammer zwischen der drehbaren Magnetron-Zerstäubungsvorrichtung und der planaren Magnetron-Zerstäubungsvorrichtung bilden,
wobei die planare Magnetron-Zerstäubungsvorrichtung konfiguriert ist, ein flüssiges Ziel mit einem ersten Material zu enthalten und einen Materialfluss mit dem ersten Material hin zu dem drehbaren Magnetron bereitzustellen, und
wobei die drehbare Magnetron-Zerstäubungsvorrichtung konfiguriert ist, um ein festes Ziel mit einem zweiten Material bezüglich der planaren Magnetron-Zerstäubungsvorrichtung zu drehen und einen Materialfluss mit den ersten und zweiten Materialien hin zu dem flexiblen Substrat bereitzustellen.

## Revendications

1. Un système de dépôt pour le dépôt d'une cellule photovoltaïque à film mince sur un substrat flexible, comprenant :
a) une enceinte comprenant un espace pour fluide qui est isolé fluidiquement d'un environnement extérieur à ladite enceinte ;
b) une pluralité de chambres de dépôt dans ledit espace pour fluide, au moins une chambre de dépôt de ladite pluralité de chambres de dépôt comprenant un appareil de pulvérisation magnétron qui dirige un flux de matière d'une ou de plusieurs matières cibles en direction d'une portion dudit substrat flexible qui est disposé dans ladite au moins une chambre de dépôt de ladite pluralité de chambres de dépôt ;
b1) chacune desdites chambres de dépôt qui comprend un appareil de pulvérisation magnétron comportant des ouvertures à travers lesquelles passe ledit substrat flexible et des limiteurs de conductance ajustables placés au niveau desdites ouvertures pour former un écart entre ledit substrat et ledit limiteur de conductance ;
c) un rouleau dérouleur de substrat et un rouleau enrouleur de substrat dans ladite enceinte, ledit rouleau dérouleur de substrat fournissant un substrat flexible qui est dirigé à travers chaque chambre de dépôt de ladite pluralité de chambres de dépôt jusqu'audit rouleau enrouleur de substrat ; et
d) au moins un rouleau guide dans ladite enceinte, ledit rouleau guide étant configuré pour diriger ledit substrat flexible vers ou depuis une chambre de dépôt donnée parmi ladite pluralité de chambres de dépôt ;
dans lequel ladite au moins une chambre de dépôt comprend un appareil de pulvérisation magnétron comprenant :
un magnétron rotatif adjacent à un magnétron plan ; et
un ou plusieurs boucliers formant une sous-chambre entre ledit magnétron rotatif et ledit magnétron plan,
dans lequel ledit magnétron plan est configuré pour contenir une cible liquide ayant une première matière et fournir un flux de matière ayant ladite première matière en direction dudit magnétron rotatif, et
dans lequel ledit magnétron rotatif est configuré pour faire tourner une cible solide ayant une deuxième matière par rapport audit magnétron plan et fournir un flux de matière ayant lesdites première et deuxième matières en direction dudit substrat flexible.

2. Le système de dépôt de la revendication 1, dans lequel ladite première matière a un premier point de fusion qui est inférieur à un deuxième point de fusion de ladite deuxième matière.

3. Le système de dépôt de la revendication 1, dans lequel ladite première matière est du gallium et ladite deuxième matière est de l'indium.

4. Le système de dépôt de la revendication 1, dans lequel ledit magnétron rotatif est de forme au moins partiellement cylindrique.

5. Le système de dépôt de la revendication 1, dans lequel ledit magnétron plan comprend une plaque de renfort adjacente à un corps de magnétron, et dans lequel ledit corps de magnétron comporte un ou plusieurs aimants et ladite plaque de renfort est conçue pour retenir ladite cible liquide.

6. Le système de dépôt de la revendication 1, dans lequel ledit magnétron rotatif comprend un élément formant support conçu pour faire tourner ladite cible solide par rapport audit magnétron plan.

7. Le système de dépôt de la revendication 1, dans lequel ledit magnétron plan est conçu pour contenir un autre liquide ayant une troisième matière.

8. Le système de dépôt de la revendication 1, dans lequel ledit magnétron plan est configuré pour fournir un flux de ladite première matière dans ladite chambre.

9. Le système de dépôt de la revendication 1, comprenant en outre un magnétron plan supplémentaire adjacent audit magnétron plan, ledit magnétron plan supplémentaire étant configuré pour fournir un flux d'une troisième matière dans ladite chambre.

10. Le système de dépôt de la revendication 1, comprenant en outre un appareil magnétron supplémentaire adjacent audit appareil magnétron, ledit appareil magnétron supplémentaire étant configuré pour fournir un flux d'une troisième matière en direction dudit substrat.

11. Le système de dépôt de la revendication 10, dans lequel lesdits assemblages formant magnétron sont enfermés dans une autre chambre ayant une ouverture conçue pour exposer ledit substrat.

12. Le système de dépôt de la revendication 10, dans lequel ladite première matière est du gallium, ladite deuxième matière est soit de l'indium soit du cuivre, et ladite troisième matière est l'autre parmi l'indium et le cuivre.

13. Le système de dépôt de la revendication 1, comprenant en outre une source d'une troisième matière adjacente audit appareil magnétron.

14. Le système de dépôt de la revendication 13, dans lequel ladite troisième matière est du soufre ou du sélénium.

15. Un système de dépôt pour le dépôt d'une cellule photovoltaïque à film mince sur un substrat flexible, comprenant :
a) une enceinte comprenant un espace pour fluide qui est isolé fluidiquement d'un environnement extérieur à ladite enceinte ;
b) une pluralité de chambres de dépôt dans ledit espace pour fluide, ladite pluralité de chambres de dépôt comprenant une première chambre de dépôt et une deuxième chambre de dépôt, ladite première chambre de dépôt comprenant un appareil de pulvérisation magnétron qui dirige un premier flux de matière en direction d'un premier côté d'une portion dudit substrat flexible, et ladite deuxième chambre de dépôt comprenant un appareil de pulvérisation magnétron qui dirige un deuxième flux de matière en direction d'un deuxième côté de ladite portion qui se trouve en face dudit premier côté ;
b1) chacune desdites première et deuxième chambres de dépôt comportant des ouvertures à travers lesquelles passe ledit substrat flexible et des limiteurs de conductance ajustables placés au niveau desdites ouvertures pour former un écart entre ledit substrat et ledit limiteur de conductance ; et
c) un rouleau dérouleur et un rouleau enrouleur dans ladite enceinte, ledit rouleau dérouleur dirigeant de façon séquentielle ledit substrat flexible vers ledit rouleau enrouleur à travers chaque chambre de dépôt de ladite pluralité de chambres de dépôt ;
dans lequel au moins une chambre de dépôt de ladite pluralité de chambres de dépôt comprend un appareil de pulvérisation magnétron comprenant :
un appareil de pulvérisation magnétron rotatif adjacent à un appareil de pulvérisation magnétron plan ; et
un ou plusieurs boucliers formant une sous-chambre entre ledit appareil de pulvérisation magnétron rotatif et ledit appareil de pulvérisation magnétron plan,
dans lequel ledit appareil de pulvérisation magnétron plan est configuré pour contenir une cible liquide ayant une première matière et fournir un flux de matière ayant ladite première matière en direction dudit magnétron rotatif, et
dans lequel ledit appareil de pulvérisation magnétron rotatif est configuré pour faire tourner une cible solide ayant une deuxième matière par rapport audit appareil de pulvérisation magnétron plan et fournir un flux de matière ayant lesdites première et deuxième matières en direction dudit substrat flexible.
